(19) Europäisches Patentamt

European Patent Office

Office européen des brevets

(11) **EP 3 360 174 B1**

(12) **FASCICULE DE BREVET EUROPEEN**

(45) Date de publication et mention
de la délivrance du brevet:
**08.12.2021 Bulletin 2021/49**

(21) Numéro de dépôt: **16788170.5**

(22) Date de dépôt: **04.10.2016**

(51) Int Cl.:
*H01L 51/52* (2006.01)        *C08F 220/18* (2006.01)
*C08F 220/32* (2006.01)        *C09J 4/06* (2006.01)

(86) Numéro de dépôt international:
**PCT/FR2016/052543**

(87) Numéro de publication internationale:
**WO 2017/060609 (13.04.2017 Gazette 2017/15)**

(54) **ADHÉSIF DONT LE PRÉCURSEUR EST APPLIQUÉ SOUS FORME LIQUIDE ET POLYMÉRISÉ UV, POUR L'ENCAPSULATION DE DISPOSITIFS ÉLECTRONIQUES FLEXIBLES, AMÉLIORANT LA PROTECTION CONTRE LA PERMÉABILITÉ AUX GAZ**

KLEBSTOFF MIT FLÜSSIG AUFGETRAGENEM UND UV-POLYMERISIERTEM VORLÄUFER ZUR VERKAPSELUNG VON FLEXIBLEN ELEKTRONISCHEN VORRICHTUNGEN, VERBESSERUNG DES SCHUTZES GEGEN GASDURCHLÄSSIGKEIT

ADHESIVE, THE PRECURSOR OF WHICH IS APPLIED IN LIQUID FORM AND UV-POLYMERIZED, FOR ENCAPSULATING FLEXIBLE ELECTRONIC DEVICES, IMPROVING THE PROTECTION AGAINST GAS PERMEABILITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.10.2015 FR 1559456**

(43) Date de publication de la demande:
**15.08.2018 Bulletin 2018/33**

(73) Titulaires:
• **Arkema France**
**92700 Colombes (FR)**
• **Commissariat à l'Énergie Atomique
et aux Énergies Alternatives
75015 Paris (FR)**

(72) Inventeurs:
• **HIDALGO, Manuel**
**69530 Brignais (FR)**
• **CROS, Stéphane**
**73000 Chambery (FR)**
• **BOLDRIGHINI, Patrick**
**Littleton, Massachusetts 01460 (US)**

(74) Mandataire: **IP Trust**
**2, rue de Clichy**
**75009 Paris (FR)**

(56) Documents cités:
**WO-A1-2011/138630        WO-A1-2014/025386
WO-A1-2014/104522        CN-A- 101 993 513
FR-A1- 2 501 213        US-A1- 2014 179 040**

**Description**

Le réchauffement climatique, lié aux gaz à effet de serre dégagés par les énergies fossiles, a mené au développement de solutions énergétiques alternatives qui n'émettent pas de tels gaz lors de leur fonctionnement, comme par exemple les modules photovoltaïques.

Le domaine de l'invention est celui de l'encapsulation de ce type de modules et de dispositifs électroniques ou optoélectroniques, afin de les protéger contre la perméation des gaz et en particulier de la vapeur d'eau et de l'oxygène.

Il inclût plus particulièrement l'encapsulation de dispositifs électroniques ou optoélectroniques flexibles c'est à dire qui conservent leurs propriétés conductrices ou semi-condutrices électroniques même lorsque pliés avec un rayon de courbure très faible sans risque de flambage ou de délaminage des composants électroniques.

Ces dispositifs électroniques ou optoélectroniques flexibles sont en passe de s'imposer comme les éléments clef de l'électronique à faible coût. Ils trouvent leurs applications dans des composants tels que les appareils à diodes électroluminescentes organiques (DELOs pour l'acronyme français, OLEDs pour l'acronyme anglais utilisé préférentiellement dans la suite), les cellules photovoltaïques organiques (OPV pour l'acronyme anglais utilisé dans la suite), les transistors organiques (OFETs pour l'acronyme anglais utilisé dans la suite), les mémoires ou les capteurs. La commercialisation d'écrans courbés à base de diodes électroluminescentes organiques a démontré l'intérêt de la filière organique. Les cellules photovoltaïques organiques sont quant à elles prometteuses pour la production d'énergie à bas coût. Contrairement aux cellules à base de silicium cristallin, elles peuvent être aisément fabriquées sur substrat souple, ce qui leur permettra de s'intégrer facilement dans les objets courants. Pour les transistors organiques, un avantage important par rapport au silicium réside dans la possibilité de déposer ces matériaux sur des substrats à basse température, les rendant compatibles avec des substrats flexibles.

L'encapsulation est réalisée par des films dits barrière peu perméables aux gaz, en particulier à la vapeur d'eau et à l'oxygène, et qui doivent être au moins autant flexibles que le dispositif électronique qu'ils protègent afin de ne pas devenir un facteur limitant la flexion de celui-ci, ou qui doivent présenter une flexibilité contrôlée lorsque par exemple, l'encapsulation est utilisée pour limiter sciemment, le rayon de courbure du dispostif (et éviter ainsi son endommagement).

On obtient suite à l'encapsulation du dispositif électronique, un assemblage électronique encapsulé.

**Encapsulation de dispositifs électroniques ou optoélectroniques classiques**

Les panneaux photovoltaïques pour la production d'électricité les plus répandus actuellement, contiennent des cellules photovoltaïques à base de silicium mono ou multi-cristallin, qui sont donc relativement rigides et fragiles et ne supportent pas de flexion ou une flexion à rayon important.

Au sein du panneau, ces cellules sont reliées entre elles électriquement par des rubans métalliques conducteurs formant ainsi des guirlandes de cellules photovoltaïques. Ces guirlandes sont incluses dans un matériau encapsulant adhésif, et protégées, notamment contre la perméation orthogonale des gaz, par une feuille protectrice avant (ou face avant (FAV)) et par une feuille protectrice au dos du module (ou face arrière (FAR)), qui sont chacune disposées contre chaque face de l'encapsulant. L'assemblage des modules et des feuilles protectrices s'éffectue par laminage à chaud et réticulation de l'encapsulant englobant les cellules.

Protection contre la perméation orthogonale dans des modules photovoltaïques classiques à base de silicium cristallin

En fonction de la technologie des cellules photovoltaïques à protéger et des caractéristiques souhaitées pour l'assemblage incluant ces cellules, l'encapsulant, les faces avant et arrière devront présenter des propriétés particulières pour assurer une protection efficace contre la perméation orthogonale des gaz.

Ainsi, pour les cellules photovoltaïques à base de silicium précitées :

- l'encapsulant est généralement constitué par un épais film polymère solide généralement à base de copolymère éthylène/acétate de vinyle (EVA) (ou autre) d'une épaisseur généralement supérieure à quelques centaines de microns afin de réaliser un enrobage optimal des cellules, et

- la face avant est constituée en verre qui offre une excellente protection à la perméation orthogonale des gaz et contre l'humidité, une bonne protection aux chocs, une bonne résistance au vieillissement une bonne transparence mais présente un poids conséquent du fait de son épaisseur typique de l'ordre de 3 mm

- la face arrière est généralement constituée par une structure multi-couche contenant du poly (téréphtalate d'éthylène) (PET) entre deux couches à base d'un polymère fluoré comme le poly(fluorure de vinyle) (PVF) ou le poly(fluorure de vinylidène) (PVDF) et assure une bien moindre protection des cellules contre la perméation orthogonale aux gaz que la face avant en verre, mais assure l'isolation électrique des cellules, le blocage des rayons UV, entre autre. Ces dernières années, des faces arrière à base d'autres polymères que les polymères fluorés se sont développées et dans certains cas, même la couche de PET a été remplacée par d'autres polymères, sans que cela ne change rien au problème de la moindre performance en terme de protection contre la perméation orthogonale des gaz, de ces faces arrières multi-couches polymères, comparées au verre.

Pour pallier l'inconvénient du poids de la face avant en verre de ces modules, il peut exister des configurations où celui-ci a été substitué par des films ou plaques polymères.

Ceux-ci présentant cependant une piètre protection contre la perméation des gaz. Ce défaut peut cependant être au moins partiellement compensé par l'utilisation d'épaisseurs importantes de l'ordre de plusieurs millimètres.

Du fait de l'épaisseur significative avec laquelle il est utilisé pour assurer une résistance à la perméation aux gaz satisfaisante, le matériau constitutif du film ou plaque polymère qui peut être utilisé en remplacement du verre sur la face avant d'un module ne présente pas de caractère flexible au sein de l'assemblage réalisé même s'il peut intrinsèquement présenter une certaine flexibilité.

Cette absence de flexibilité du film ou plaque polymère de protection et/ou de l'encapsulant dans l'assemblage réalisé n'est toutefois pas problématique dans le cadre de la protection de cellules à base de silicium mono ou multi-cristallin puisque celles-ci n'ont pas vocation à être utilisées en flexion du fait de leurs fragilité et rigidité intrinsèques.

Protection contre la perméation latérale dans les modules photovoltaïques classiques à base de silicium cristallin

Dans ce type de structure de module PV classique à base de silicium cristallin, protégé par une face avant en verre ou polymère épaisse, et une face arrière en polymère (généralement des structures multi-couches), le point de pénétration des gaz le plus important est la face arrière en polymère de surface transversale beaucoup plus importante que la surface exposée latéralement aux gaz. La perméation latérale est donc infime en comparaison de la perméation orthogonale dont la face arrière est le siège. D'autant que ces modules à structure classique comportent en outre un cadre en aluminium enserrant la périphérie de l'encapsulant venant limiter la perméation latérale aux gaz déjà infime en comparaison à la perméation orthogonale.

Arrière-plan de l'invention

**Encapsulation de dispositifs flexibles**

Parmi les technologies photovoltaïques qui ont été développées en remplacement des dispositifs rigides à base de silicium, les dispositifs photovoltaïques organiques représentent une alternative particulièrement intéressante.

Ces dispositifs utilisent des molécules organiques et des polymères comme matériau semi-conducteur à la place du silicium et comprennent une couche active mince (quelques centaines de nanomètres d'épaisseur) non fragile et qui est déposée sur un substrat polymère, lui permettant d'être flexible et d'être mise en forme par laminage à basse température.

Afin d'encapsuler des dispositifs électroniques ou optoélectroniques de ce type, comme par exemple, des cellules solaires organiques flexibles, il est d'usage de laminer sur ces dernières un film barrière aux gaz via un adhésif de part et d'autre du substrat polymère sur lequel reposent les cellules solaires organiques.

Le film barrière aux gaz est composé d'un substrat polymère sur lequel est déposée une structure barrière aux gaz.

Le rôle de cette structure barrière (de quelques microns au plus, d'épaisseur) est d'améliorer les propriétés barrière du substrat polymère ; ces dernières étant en effet insuffisantes pour protéger des dispositifs sensibles tels que des dispositifs d'électronique organique, de la perméation aux gaz.

En effet, les films polymères ont des perméabilités aux gaz, souvent exprimés en termes du flux de perméation ou WVTR (water vapor transmission rate) de l'ordre de 1 à 100 g.m$^{-2}$.j$^{-1}$ (gramme/(mètre carré - jour) alors que les requis barrière pour des applications d'électronique organique sont compris entre 10$^{-3}$ et 10$^{-6}$ g.m$^{-2}$.j$^{-1}$ selon la technologie à protéger (encapsuler) et/ou la durée de vie visée.

Les structures barrières flexibles et transparentes déposées sur un dispositif à protéger et correspondant aux requis définis, peuvent être de nature très variable, mais les plus efficaces d'entre elles comprennent de préférence une ou plusieurs couches denses inorganiques, généralement constituées d'un oxyde métallique tel le SiOx, AlOx, Zn/SnOx, etc..), d'une épaisseur type de quelques centaines de nanomètres.

Afin d'atteindre des propriétés barrière en deçà de 10$^{-1}$ - 1 g.m$^{-2}$.j$^{-1}$, tout en dotant la structure barrière d'une certaine flexibilité, il est généralement nécessaire de réaliser des structures dites multicouches comportant une alternance de couches denses inorganiques et de couches molles organiques (d'une épaisseur typique de 1 à quelques microns), conformément au document WO2013/045393.

Afin de mettre en œuvre l'encapsulation du dispositif, il est nécessaire de laminer de part et d'autre du dispositif déposé sur le substrat polymère, le film barrière via un adhésif qui permet d'assurer la cohésion avec le dispositif.

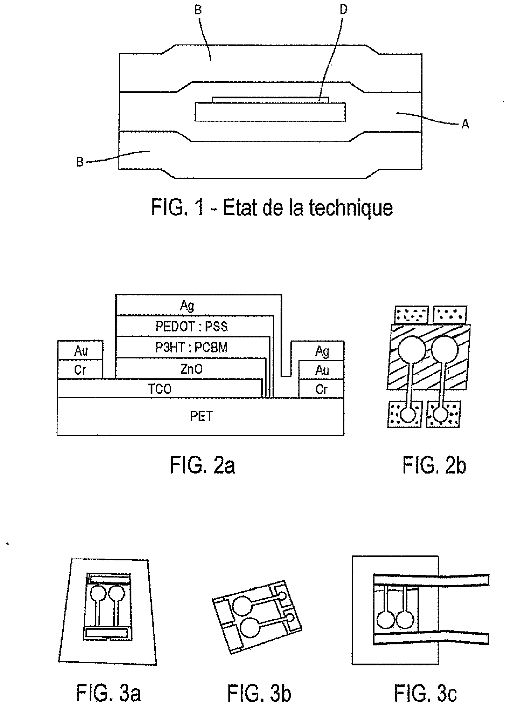

Un schéma de principe d'un dispositif reposant sur un support plastique et encapsulé par lamination d'un film barrière est représenté sur la figure 1.

Sur ce schéma, les gaz de l'atmosphère dont on cherche à protéger le dispositif (eau, oxygène principalement) peuvent atteindre le dispositif selon des processus de perméation orthogonale (perpendiculairement au plan du module et ainsi au travers des films barrières) et selon des processus de perméation latérale (dans le plan du module : à travers l'adhésif depuis son bord libre périphérique, et aux interfaces entre l'adhésif et la structure barrière).

Protection contre la perméation orthogonale

La protection du dispositif contre la perméation orthogonale est assurée par deux structures barrières flexibles précitées qui donnent généralement satisfaction. Ces structures présentent des propriétés barrières au gaz pouvant être satisfaisantes pour certaines applications et en tout état de cause, meilleures que celles obtenues par les films polymères, avec les exemples présentés dans le document WO2013/045393 précité.

Protection contre la perméation latérale

La protection du dispositif contre la perméation latérale est principalement assurée par l'adhésif qui constitue le maillon le plus permeable de la structure.

Elle dépend ainsi notamment des propriétés barrières de l'adhésif, parmi lesquelles :

1. Les propriétés barrière intrinsèques de l'adhésif (du fait de sa nature chimique et du procédé d'application) : Ces propriétés intrinsèques vont conditionner, en grand partie, le niveau de perméation latérale que l'adhésif aura.
2. L'épaisseur de l'adhésif : le flux de gaz atteignant le dispositif provenant de la masse de l'adhésif (bulk) sera en effet proportionnel à la surface d'échange avec l'atmosphère (et donc à l'épaisseur de l'adhésif) (lois de la perméation ou lois de Fick)
3. Les interfaces entre l'adhésif et le film barrière : des interfaces faibles, du fait d'une faible énergie d'adhésion, sont une voie de passage privilégiée pour les gaz de l'atmosphère
4. Les défauts de la couche d'adhésif : si le dispositif possède une forte topologie (structures multicouches plus, éventuellement, sortie de connectiques), il est important que la couche d'adhésif planarise correctement le dispositif afin de ne pas créer de voies de passage des gaz de l'atmosphère non obturées par l'adhésif.
5. Compatibilité du mode de dépôt de l'adhésif et du procédé associé (séchage, conversion) avec le dispositif à encapsuler
6. Compatibilité de l'adhésif lui même avec le dispostif (dégradation possible du fait de la chimie de l'adhésif (formulation et/ou solvant)
7. Résistance de l'adhésif aux contraintes d'usage du dispositif : flexibilité, vieillissement photochimique

Compte tenu de ces contraintes reposant sur l'adhésif qui ne présente généralement pas de propriétés barrières intrinsèques particulièrement élevées du fait de sa nature polymérique organique peu dense, c'est généralement la perméation latérale aux gaz qui est la plus critique dans les dispositifs incluant un module organique flexible encapsulé par deux structures multicouches barrières aux gaz.

A ce titre, dans les documents EP 2 781 568 et EP 2 637 229 déposés par LG Chem, les adhésifs utilisés préférentiellement sont de la famille des époxy, largement connus du grand public et de l'homme de l'art et sont combinés à des absorbeurs d'humidité de type oxyde métallique. Cependant, les adhésifs époxy présentent également des inconvénients dans le domaine de l'invention du fait de leur mauvaise tenue au vieillissement en extérieur, du fait des attaques photochimiques que la lumière, l'oxygène et l'humidité peuvent provoquer à leur structure chimique.

On connaît du document US 2014/179040 un procédé d'encapsulation d'un dispositif électronique pour le protéger contre l'humidité et/ou l'oxygène. Ce procédé propose l'encapsulation du dispositif électronique par différentes couches soit par dépôt (ALD notamment) ou « spin coating », soit par un transfert par une méthode de scellement sous vide. Ces étapes sont suivies d'une polymérisation des monomères.

L'invention vise à proposer un adhésif susceptible d'améliorer la protection latérale à la perméation aux gaz de dispositifs électroniques flexibles encapsulés entre deux feuilles protectrices ou entre deux structures barrières multicouches, tout en conservant leur flexibilité et leur intégrité lors du procédé d'encapasulation et dans le temps.

Exposé de l'invention

L'invention utilise une formulation adhésive permettant une amélioration significative des propriétés de perméation latérale de l'encapsulation d'un dispositif électronique tout en offrant la possibilité de conserver au maximum les propriétés de flexibilité de ce dispositif lorsqu'il en est pourvu.

A cet effet, l'invention concerne un procédé d'encapsulation d'un dispositif électronique flexible avec au moins une feuille flexible de protection contre la perméation orthogonale aux gaz, par l'intermédiaire d'un adhésif de protection contre la perméation latérale aux gaz, le procédé comprenant :

- une étape d'application d'une couche d'un précurseur polymérisable d'adhésif de protection contre la perméation latérale aux gaz, sur la surface du dispositif et/ou sur la surface de la feuille flexible de protection aux gaz, le précurseur d'adhésif comprenant des oligomères à double liaisons réactive de type (méth)acryliques, et un amorceur de polymérisation
- puis, une étape de polymérisation du précurseur d'adhésif appliqué, alors qu'il se retrouve disposé entre le dispositif et la feuille de protection aux gaz, afin de constituer l'adhésif solidarisant la feuille de protection au dispositif tout en protégeant le dispositif de la perméation latérale aux gaz.

Le procédé selon l'invention peut par ailleurs présenter l'un et/ou l'autre des aspects suivants :

- le précurseur d'adhésif présente à l'état non polymérisé, lors de l'application sur la surface du dispositif et/ou sur la surface de la feuille flexible de protection aux gaz, une viscosité dynamique comprise entre $10^{-3}$ et $10^1$ Pa.s pour un taux de cisaillement de 1 $s^{-1}$ de préférence entre 10 mPa.s à 100 000 mPa.s pour un taux de cisaillement de 1 $s^{-1}$, avantageusement entre 50 mPa.s et 75 000 mPa.s pour un taux de cisaillement de 1 $s^{-1}$

- le précurseur d'adhésif est polymérisable par irradiation UV,
- la couche de précurseur d'adhésif est appliquée à l'état non polymérisé sur une épaisseur prédéterminée permettant de doter l'adhésif formé après polymérisation, d'une épaisseur inférieure ou égale à 3000 microns, de préférence inférieure ou égale à 150 microns,
- le précurseur d'adhésif comprend en outre une résine tackifiante,
- le précurseur d'adhésif comprend des monomères (meth)acryliques, et les oligomères sont fonctionnalisés avec des groupes (méth)acryliques,
- le monomère est un monomère meth(acrylique),
- le monomère comprend un acrylate de alkyl-phénol éthoxylé,
- l'oligomère à doubles liaisons réactives est un oligomère fonctionnalisé avec des groupes (méth)acryliques,
- l'oligomère fonctionnalisé avec des groupes (méth)acryliques est choisi parmi la famille des époxy (meth)acrylate aromatiques, des (meth)acrylates aliphatiques difonctionnels ou un mélange de ceux-ci,
- l'oligomère fonctionnalisé avec des groupes (méth)acryliques est un oligomère comprenant un diacrylate uréthane alyphatique et 10% de 2-(2éthoxy éthoxy) éthyl acrylate,
- l'amorceur de polymérisation est choisi parmi le 2-hydroxy-2-methyl-1-phenyl-propan-1-one, 2,4,6-trimethylbenzoyl-diphenyl-phosphineoxide, 1-hydroxy-cyclohexyl-phenyl-cétone, bis(2,6-dimethoxybenzoyl)-2,4,4-trimethyl-pentyl phosphine oxide, 1-[4-(2-hydroxyethoxy)-phenyl]-2-hydroxy-2-methyl-1-propane-1-one, 2,2-dimethoxy-1,2-diphenylethan-1-one et le 2-methyl-1[4-(methylthio)phenyl]-2-morpholinopropan-1-one,

## Définitions

Le terme « (méth)acrylique » tel qu'utilisé se rapporte à tout type de monomères acryliques ou méthacryliques.

Le terme « PMMA » tel qu'utilisé se rapporte aux homo- et copolymères de méthacrylate de méthyle (MMA), le rapport en poids de MMA dans le PMMA étant d'au moins 50%, de préférence au moins 55%, de manière encore préférée au moins 70 % en poids pour le copolymère de MMA.

Le terme « monomère » tel qu'utilisé se rapporte à une molécule simple, présentant un unique motif de répétition, de masse molaire inférieure à 300 g/mole, qui peut subir une polymérisation.

Le terme « oligomère» tel qu'utilisé se rapporte à une molécule de masse molaire supérieure à 300 g/mole, et qui peut subir une polymérisation.

Le terme « polymérisation » tel qu'utilisé se rapporte au procédé de transformation d'un monomère ou d'un mélange de monomères en un polymère.

Le terme « polymère thermoplastique » tel qu'utilisé se rapporte à un polymère qui se transforme en un liquide ou devient plus liquide ou moins visqueux lorsqu'il est chauffé et qui peut prendre de nouvelles formes par l'application de chaleur et de pression.

Le terme « polymère thermodurcissable » tel qu'utilisé se rapporte à un prépolymère à un état souple, solide ou visqueux qui se transforme de manière irréversible en un réseau polymère insoluble et infusible par réticulation.

Le terme « réticulation » tel qu'utilisé se rapporte au processus chimique permettant de lier entre elles, des molécules pour former un réseau tridimensionnel.

Le terme « initiateur » ou « amorceur » tel qu'utilisé se rapporte à une espèce chimique qui réagit avec un monomère pour former un composé intermédiaire capable de se lier avec succès à un grand nombre d'autres monomères ou à d'autres composés intermédiaires pour former un composé polymère. Si les monomères présentent un nombre de fonctions réactives suffisant, par exemple si la fonctionalité moyenne d'une partie au moins des monomères est supérieure ou égale à deux, on peut obtenir un système réticulé.

Le terme « flexible » est à comprendre comme la faculté d'un matériau, du fait de ses propriétés intrinsèques et/ou de sa faible épaisseur à se fléchir, se courber, se plier aisément. La couche d'adhésif utilisée et la feuille de protection pourront avantageusement présenter de par leurs propriétés mécaniques (faible rigidité) et/ou leur épaisseur, une flexibilité égale ou supérieure à celle du substrat flexible sur lequel est déposé l'élément électronique flexible (éventuellement organique), typiquement, un substrat de PET de 10 à 250 microns d'épaisseur. Le substrat, la couche d'adhésif utilisée et la feuille de protection pourront être déformés pour présenter un rayon de courbure de 10 cm sans subir de dégradation structurelle ou fonctionelle.

Le terme « particules extra-fines » est à comprendre comme des particules présentant dans au moins une direction, une longueur moyenne inférieure ou égale à 20 microns, de préférence à 10 microns, de préférence à 6 microns, de préférence à 1 micron, de préférence à 300 nm, de préférence à 100 nm ; en étant supérieure ou égale à 10 nm, de préférence à 30 nm. Ces particules peuvent se présenter sous différentes formes (sphériques, cubiques, parallélépipédiques, lamellaires). Ces nanoparticules comprennent des nanoparticules présentant une structure lamellaire définissant des couches d'une taille inférieure ou égale à 20 microns, de préférence inférieure ou égale à 10 microns, de préférence, inférieure ou égale à 6 microns ; et/ou sont sphériques et présentent un diamètre moyen inférieur ou égal à 1 micron, de préférence inférieur ou égal à 300 nm, de préférence inférieur ou égal à 100 nm, de préférence inférieur ou égal à 60 nm. Les dimensions des particules extra-fines, telles que leurs diamètres ou longueurs, peuvent être établies par microscopie électronique ou diffusion de lumière.

Le terme « température ambiante » désigne la température de 25°, à moins qu'il ne ressorte explicitement de son emploi dans le texte qu'il désigne d'une température différente.

On entend par « assemblage électronique flexible » un ensemble incluant un dispositif électronique flexible comprenant un élément électronique (de type polymère électronique ou dispositif (opto)électronique comportant des couches minces) éventuellement monté sur un substrat flexible, et protégé de la perméation aux gaz par au moins une feuille de protection contre la permémation des gaz. L'assemblage flexible peut être déformé pour présenter un rayon de courbure de 10 cm sans subir de dégradation structurelle ou fonctionelle.

On entend par l'expression « compatible avec le substrat ou le dispositif électronique » un composé, monomère, adhésif, précurseur d'adhésif qui n'altère pas ou peu (moins de 20%, de préférence 10%, de préférence 5%), le fonctionnement du dispositif (par exemple le rendement de conversion pour une cellule photovoltaïque).

Dans le présent texte et les figures, le point « . » ou la virgule « , » sont indifféremment utilisés comme séparateurs décimaux.

## Description des figures

L'invention sera décrite en référence aux figures annexées qui illustrent des modes de réalisations ainsi que les résultats expérimentaux obtenus avec ceux-ci :

- La figure 1 représente schématiquement une configuration connue d'encapsulation flexible d'un composant électronique flexible D, comprenant deux films barrières B et une couche d'adhésif A
- La figure 2 (a) : représente un schéma en coupe d'une cellule OPV, donné à titre d'exemple dans la présente invention, avec les différentes couches identifiées (schéma non à l'échelle). 2(b) : Une image de l'arrière d'une cellule terminée. Les parties hachurées représentent la couche active, alors que les régions à fond blanc correspondent aux électrodes en argent, et les régions pointillées, aux plages en or.
- La figure 3 : représente des images de cellules OPV encapsulées après vieillissement, pour les schémas d'encapsulation (a) directe, (b) par électrode ouverte et (c) par ruban

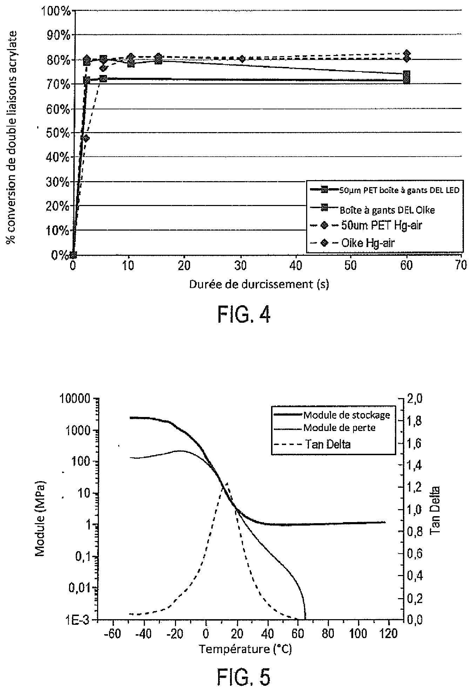

- La figure 4 indique le durcissement de F18 calculé à partir des mesures FTIR-ATR. Des échantillons ont été durcis entre des substrats PET de $50\mu$m ou des substrats Oike VX 25T-2PO. Les lampes consistaient en une source DEL (acronyme français pour diode électroluminescente, acronyme anglais : LED préférentiellement utilisé dans ce texte) de 400 nm placée dans une boîte à gants sous azote sec et une source à mercure à moyenne pression placée dans l'air.
- La figure 5 montre la courbe DMTA de F18 soumis à un essai d'analyse mécanique dynamique en mode traction, suivant une rampe de montée en température de 3°C/min, sous une fréquence fixe de sollicitation de 1Hz et une déformation maximale de 0,1%.

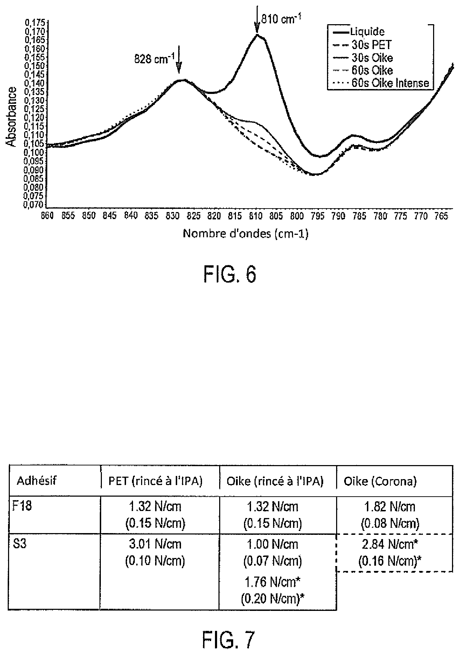

- La figure 6 illustre les spectres FTIR-ATR de S3 pour différentes durées de durcissement et divers substrats. Les échantillons, sauf pour le liquide, ont été durcis à l'aide d'une lampe à mercure moyenne pression, dans l'air. La conversion de l'adhésif peut être observée au niveau du pic à 810cm-1, correspondant à la flexion hors plan des motifs C-H sur RCH=CH2.

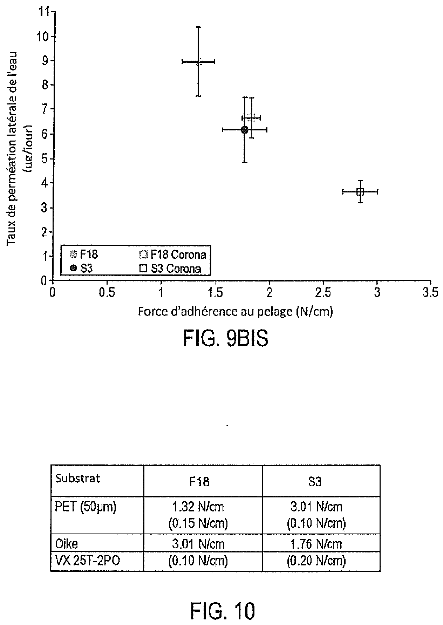

- Les figures 7 et 10 représentent la force d'adhérence ou de résistance au pelage des adhésifs (méth)acryliques polymérisés/réticulés aux UV, sur différents substrats, avec l'écart type entre parenthèses. L'épaisseur d'adhésif des échantillons était d'environ 50µm. Les astérisques correspondent à un traitement de polymérisation/réticulation (durcissement) plus long et intense

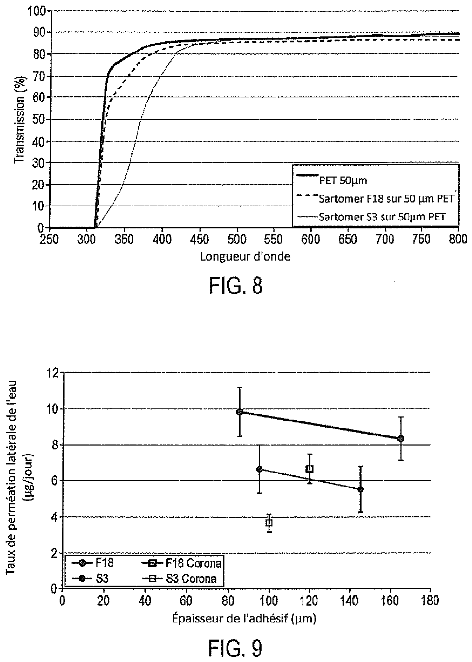

- La figure 8 montre une courbe de spectroscopie UV-Visible utilisant un détecteur standard, réalisée sur un film PET d'une épaisseur de 50µm et sur des films PET revêtus d'un adhésif d'une épaisseur de 50µm. Pour les échantillons d'adhésifs, la surface du PET faisait face à la source laser, de sorte que la réflexion soit identique pour l'ensemble des échantillons.
- Les figures 9, 9bis : représentent un graphique illustrant la perméation latérale mesurée en micro grammes par jour (µg.j-1) de deux adhésifs selon l'invention avec ou sans résine tackifiante, avec ou sans traitement corona du substrat) en fonction de l'épaisseur de ces adhésifs (figure 9) et de leur force d'adhésion déterminée par le test de pelage (figure 9BIS). Le taux de perméation latérale apparente a été mesuré par un test de calcium optique tel qu'explicité ci-après. Les valeurs ont toutes été normalisées à des dépôts de calcium de 45mm X 45mm pour tenir compte des légères différences entre les échantillons. Les barres d'erreur représentent un écart-type
- la figure 10 représente par un tableau, la force d'adhérence moyenne en test de pelage en « T » des adhésifs acrylates UV polymérisables/réticulables F18 et S3 avec l'écart type entre parenthèses. Tous les échantillons ont présenté une épaisseur d'environ 50 µm d'adhésif. Les échantillons testés ont présenté une rupture cohésive à l'interface adhésif-substrat, sauf l'échantillon S3 monté sur substrat Oike ayant subi un traitement Corona qui a présenté une rupture cohésive dans l'adhésif.

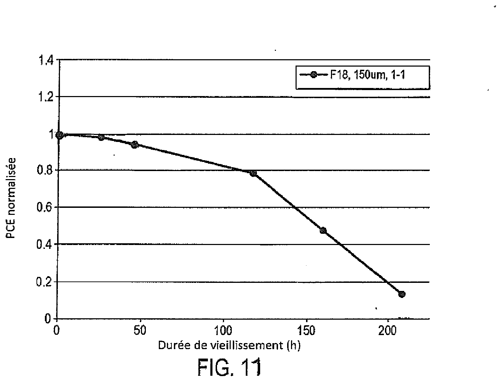

- la figure 11 représente par un graphique, une courbe de rendement de conversion de photons (acronyme en anglais PCE) d'une cellule OPV avec électrode de type ouverte (tel qu'explicité ultérieurement), encapsulée avec des films barrières Oike VX-25T 2PO, après stockage pendant des durées différentes à 65°C et à une humidité relative de 85%, sans éclairage.

## Description détaillée

### Présentation générale de l'invention

Les dispositifs flexibles encapsulables à l'aide du procédé d'encapsulation selon l'invention comprennent les dispositifs photovoltaïques organiques.

L'invention s'applique à d'autres dispositifs électroniques flexibles tels que les :

- Dispositifs électroniques organiques de type Diode électroluminescente organique (OLED) réalisés par exemple sur un support souple, transistors organiques en couches minces (acronyme français : TOCM, acronyme anglais : TFOT) réalisés par exemple sur support souple
- Dispositifs solaires en couche mince de type CIGS pour « cuivre, indium, sélénure de gallium» et qui désigne à la fois une technique d'élaboration des cellules photovoltaïques (à couches minces inorganiques et hautes performances) et le matériau semi-conducteur fait d'un alliage permettant de réaliser ces cellules.

La figure 1 représente une configuration connue d'encapsulation flexible d'un dispositif ou composant électronique flexible, comprenant deux films barrières B, positionnés de part et d'autre du composant D, et un adhésif A permettant de maintenir les films barrières sur le composant et de l'encapsuler. D'une manière générale, on appelle « schéma d'encapsulation » l'ensemble des éléments déployés pour isoler le composant de l'oxygène et de l'eau présent dans l'environnement, généralement sous forme de vapeur.

L'adhésif obtenu suite à la polymérisation du précurseur selon l'invention peut être utilisé pour solidariser au dispositif électronique souple, des feuilles de protection particulièrement adaptées aux dispositifs électroniques flexibles.

Un exemple de ce type de feuille est une structure multicouche comportant un substrat et un premier empilement d'une couche de $SiO_2$ et une couche en matériau de type $SiO_xN_yH_z$ disposée entre le substrat et la couche de $SiO_2$ telle que décrite dans la demande de brevet WO2013/045393, ou WO2013/140101.

### Formulations de précurseurs d'adhésifs

Les formulations de précurseurs d'adhésif selon l'invention sont liquides ou faiblement visqueuses, non solvantées, polymérisables à basse température (par exemple à température ambiante entre 15 et 35°C), comprennent des oligomères à double liaisons réactive ou des monomères et des oligomères à doubles liaisons réactives de type(meth)acryliques et sont susceptibles d'accueillir des charges et des additifs facilement dispersables et permettant de modifier de manière radicale les caractéristiques mécaniques, adhésives et de perméation de la couche d'adhésif barrière qui sera finalement présente dans la structure protégeant le dispositif.

Les formulations de précurseur d'adhésifs selon l'invention conservent l'avantage d'être liquides au moment de l'application sur le dispositif à encapsuler, mais leurs fonctions polymérisables ne sont pas de nature chimique époxydique.

Les monomères/oligomères utilisés dans ces formulations peuvent comprendre des fonctions de nature chimique (méth)acrylique, et présentent une grande résistance au vieillissement en extérieur tout en rendant possible et aisée la modification de leurs propriétés rhéologiques (ou d'écoulement), ainsi que leurs propriétés adhésives ou de perméation par l'ajout d'additifs en leur sein et/ou par le choix des monomères/oligomères constitutifs du précurseur d'adhésif.

Les formulations de précurseur d'adhésif selon l'invention ont l'avantage d'être liquides avant polymérisation tout en conduisant après polymérisation à des adhésifs résistants au vieillissement à l'extérieur, respectant la flexibilité du dispositif électronique qu'ils encapsulent et présentant également des propriétés intéressantes pour des applications en intérieur (oled, détecteurs).

Il s'agit de formulations sans solvants qui, de plus, polymérisent à basse température dans des temps de conversion très courts.

La présence des oligomères à doubles liaisons réactives assure une polymérisation « douce » du précurseur, évitant ou limitant le phénomène de retrait de l'adhésif à l'issue de ce phénomène, ce qui contribue à sa performance en terme de perméabilité à l'eau et au dioxygène.

De par leur nature chimique faisant appel à de multiples combinaisons possibles de monomères et oligomères de la famille des monomères/oligomères photo-polymérisables, les formulations selon l'invention peuvent facilement être ajustées en termes de comportement à l'écoulement (rhéologie), dont une des propriétés principales est la viscosité et son évolution en fonction du taux de cisaillement. La possibilité de formuler les adhésifs pour adapter leur rhéologie au mode de dépôt sur le dispositif est d'une importance primordiale pour les applications industrielles à haute cadence de ces adhésifs. Elles peuvent également être ajustées en termes de résistance photochimique selon le domaine d'application visé grâce aux différentes combinaisons de monomères et oligomères possibles. De plus, les formulations selon l'invention peuvent également accueillir en leur sein des additifs et des charges pouvant permettre d'améliorer encore leurs performances en termes d'adhésion, propriétés mécaniques et perméabilité à l'eau et au dioxygène.

En particulier, il a été trouvé que l'ajout de résines tackifiantes (améliorant le « tack » ou « pégosité »), capables d'améliorer l'adhésion pouvait se faire de manière aisée sur ces formulations c'est à dire dans des teneurs massiques significatives.

De manière préférée, des résines tackifiantes hydrophobes permettant une amélioration de l'adhésion sans dégrader les performances en perméabilité, peuvent facilement être incorporées au sein des formulations de l'invention.

Il a également été trouvé qu'il est possible d'incorporer facilement des charges dans la formulation ; ces charges, de nature active (dite « getters » ou capteurs d'eau) ou passive (sans effet de captage d'eau) sont facilement dispersables dans les formulations liquides de l'invention et peuvent également être combinées en leur sein.

Un autre avantage de ces formulations est que, de manière surprenante, elles conduisent à des adhésifs avec des propriétés barrières latérales améliorées par rapport à des produits de l'art antérieur, qui ne sont pas ou qui sont très peu fonction de l'épaisseur, dans un domaine d'épaisseur où les performances des adhésifs de l'art antérieur sont très dépendantes de l'épaisseur, comme attendu, selon l'aspect 2 de la liste ci-dessus sur les aspects critiques. Cela permet d'envisager une bonne conformation aux dispositifs à protéger, par l'augmentation de l'épaisseur de la couche adhésive, sans que cela n'entraîne fatalement une dégradation de la perméabilité comme pour les adhésifs de l'art antérieur.

Plus précisément, un précurseur d'adhésif développé, conforme à l'invention, est composé d'un mélange de monomères (méth)acryliques, d'oligomères à double liaisons ractives fonctionnalisés avec des groupes (méth)acryliques et de photoamorceurs.

Les oligomères peuvent comprendre une structure chimique à base d'uréthanes, de polyamides, de polyesters ou d'époxies et ils sont fonctionnalisés avec au moins un groupe (méth)acrylique.

Les photo-amorceurs peuvent, par exemple, être formés d'un mélange de 1-hydroxy-cyclohexyl-phenyl-cétone et éthyle - 2,4,6 - trimethyle-benzoyle-phényle-phosphinate.

Ces photoamorceurs permettent de provoquer une polymérisation des groupes acryliques via l'absorption de rayons de lumière de type UVA, violet et bleu (<425nm longueur d'onde).

Les formulations de précurseur d'adhésif sont liquides ou faiblement visqueuses à température ambiante et n'incluent pas de solvants, ce dernier aspect étant appréciable pour la compatibilité de la formulation de précurseur d'adhésif avec le dispositif.

La nature liquide des adhésifs permet la modification facile de la formulation avec des additifs, des résines tackifiantes, par exemple.

Exemples préférés de réalisation :

A partir de certains des monomères/oligomères ci-dessous, ont été préparées deux formulations, F18 et S3, qui se sont avérées particulièrement satisfaisantes (les informations des tableaux ci-dessous figurent telles que fournies par la société Sartomer)

| Nom du produit | Description | Température de transition vitreuse (Tg) de l'homopolymère (°C) | Fonctionnalité en groupes acryliques |
|---|---|---|---|
| SR238 | 1,6, hexane-diol diacrylate | 43 | 2 |
| SR285 | Tetrahydro furfuryl acrylate | -11 | 1 |
| SR484 | Mélange d'octyl et décyl acrylates | Non disponible | 1 |
| SR504D | Acrylate de nonyl phénol éthoxylé-(4OE) | -28 | 1 |
| SR506D | Acrylate d'isobornyle | 94 | 1 |
| SR9003 | Diacrylate de neopentyl glycol propoxylé-(2OP) | 32 | 2 |
| SR9050 | Ester d'acide monofonctionnel | Non disponible | 1 |

| Nom du produit | Description | Masse moléculaire (g/mole) | Température de transition vitreuse (Tg) de l'homopolymère (°C) | Fonctionnalité en groupes acryliques |
|---|---|---|---|---|
| CN131B | Acrylate d'epoxy aromatique | 300 | 14 | 1 |
| CN966H90 | Diacrylate d'uréthane aliphatique + 10% de 2-(2-éthoxy-éthoxy) éthyl acrylate | 7000 | -35 | 2 + 1 |
| CN9001 | Diacrylate aliphatique d'uréthane | 3250 | 54 | 2 |
| CN9002 | Diacrylate aliphatique d'uréthane | 7650 | -55 | 2 |

Composition de précurseur d'adhésif dite F18 comprenant :

- entre 40 et 80 %, de préférence entre 60 et 65 % d'un premier oligomère acrylique qui est un époxy (meth)acrylate aromatique (par exemple celui commercialisé sous la référence CN131B par Sartomer)
- entre 11 et 45 %, de préférence entre 25 et 30 % d'un deuxième oligomère acrylique qui peut être un (meth)acrylate aliphatique difonctionnel (par exemple celui commercialisé sous la référence CN9002 par Sartomer) et
- entre 4 et 8 %, de préférence entre 5 et 6 % du promoteur d'adhésion qui peut être de type ester d'acide monofonctionnel (SR9050) et
- entre 3 et 6 %, de préférence entre 5 et 6 % d'un photoinitiateur activé dans le domaine UV qui peut être du type de celui commercialisé sous la référence Irgacure 184 par BASF

- entre 0,5 et 1,5 %, de préférence entre 0,8 et 1,1% d'un deuxième photoinitiateur activé dans un domaine de longueurs d'onde plus élevées que le premier qui peut être du type de celui commercialisé sous la référence Lucirin TPO-L par BASF.

Composition de précurseur d'adhésif dite « S3 » comprenant :

- entre 25 et 35 %, de préférence entre 28 et 32 % d'un monomère acrylique qui est un acrylate d'alkyl phénol ethoxylé tel que celui commercialisé par Sartomer sous la référence SR504D
- entre 25 et 35 %, de préférence entre 28 et 32 % d'un oligomère acrylique qui comprend du diacrylate uréthane aliphatique et 0 à 30% et de préférence 0 à 10% d'un diluant réactif monofonctionnel, tel que le 2-(2-éthoxy-éthoxy) éthyl acrylate, un exemple d'un tel mélange correspondant à celui commercialisé par Sartomer sous la référence (CN966H90)
- entre 4 et 8 %, de préférence entre 4 et 6 % d'un promoteur d'adhésion de type ester d'acide monofonctionnel en groupes (méth)acryliques (tel que celui commercialisé par Sartomer sous la référence SR9050)
- entre 25 et 35 %, de préférence entre 27 et 32% d'une résine tackifiante de type de celle commercialisée sous la marque Norsolene par Arkema, comme, la résine Norsolene S95.
- entre 3 et 6 %, de préférence entre 5 et 6 % d'un photoinitiateur activé dans le domaine UV qui peut être du type de celui commercialisé sous la référence Irgacure 184 par BASF
- entre 0,5 et 1,5 %, de préférence entre 0,8 et 1,1% d'un deuxième photoinitiateur activé dans un domaine de longueurs d'onde plus élevées que le premier qui peut être du type de celui commercialisé sous la référence Lucirin TPO-L par BASF.

Méthode d'encapsulation

Le dépôt des précurseurs d'adhésifs peut être fait par plusieurs méthodes car la viscosité peut être variée par l'addition d'additifs ou par le contrôle de la température de l'adhésif.
Le dépôt des précurseurs d'adhésif est fait sur un film barrière transparent et/ou directement sur un dispositif électronique à encapsuler.
Après déposition du précurseur d'adhésif, le dispositif et film barrière sont laminés de manière à ce que le précurseur d'adhésif se trouve localisé entre le dispositif et le film barrière.
L'assemblage est ensuite illuminé sous une lampe qui produit des longueurs d'onde comprenant celles situées entre 300nm et 425nm.
Il est préférable que le substrat supportant le dispositif et disposé entre l'adhésif et la lampe soit transparent vis-àvis de cette gamme des longueurs d'onde. En fonction de l'intensité de la lampe et de la transparence du substrat, l'adhésif peut atteindre son niveau maximal de polymérisation après environ 5 secondes avec une lampe de mercure de pression moyenne, à spectre large ou avec des LEDs (light emmitting diodes) qui ont une émission de lumière à 400nm de longueur d'onde.
Lorsque le substrat n'est pas transparent vis à vis de la longueur d'onde de polymérisation de l'adhésif, pour encapsuler la face avant, et polymériser l'adhésif, il suffit de retourner le dispositif. Il est alors essentiel que le film barrière soit transparent dans la gamme de longueur d'onde considérée.

Caractérisation des propriétés barrières aux gaz _et/ou à la vapeur d'eau

Les propriétés barrières à la vapeur d'eau ont été caractérisées par un test calcium optique. Ce test utilise un dépôt de calcium métallique sur un substrat polymérique qui simule un dispositif. Cette éprouvette de calcium est ensuite laminée entre deux films barrières transparents et l'adhésif pour obtenir la structure suivante :
film barrière - adhésif - éprouvette du calcium - adhésif - film barrière.
Ce test calcium optique est décrit dans le détail dans le document publié le 17 juin 2015 sous le numéro IPCOM000242078D sur le site ip.com, à l'adresse suivante: http://priorart.ip.com/IPCOM/000242078.
Le précurseur d'adhésif est polymérisé après lamination et vieilli à 65°C et 85% humidité relative. Des images sont faites périodiquement pour regarder le niveau de dégradation du calcium. Le calcium, en effet, réagit avec l'eau rapidement pour produire de l'hydroxyde de calcium qui est transparent. C'est ainsi que le changement de transparence du calcium dans les images permet le calcul du niveau d'eau qui a traversé les films barrières et la perméation d'eau par les bords de l'échantillon est calculée par la diminution de la taille du dépôt du calcium qui se convertit progressivement en hydroxyde de calcium.
Les résultats obtenus pour des exemples préférés de réalisation explicités ci-dessous, et présentés dans les tableaux suivants, montrent que les adhésifs obtenus selon l'invention présentent des propriétés barrières à la vapeur d'eau satisfaisantes.

Compositions des exemples préférés, F18 et S3 :

| Nom du produit | Description fonctionnelle | % en masse dans la formulation F18 |
|---|---|---|
| CN131B | Oligomère à basse Tg d'homopolymère | 61,6 |
| CN9002 | Oligomère à très basse Tg d'homopolymère | 28,0 |
| SR9050 | Promoteur d'adhésion | 5,6 |
| Irgacure 184 | Photoamorceur UV-A | 3,8 |
| Lucirin TPO-L | Photoamorceur domaine visible | 1,0 |

| Nom du produit | Description fonctionnelle | % en masse dans la formulation S3 |
|---|---|---|
| CN966H90 | Oligomère diacrylate uréthane bi-fonctionnel | 29,5 |
| SR504D | Monomère monoacrylate | 30,6 |
| SR9050 | Promoteur d'adhésion | 5,6 |
| Norsolene S95 | Résine tackifiante aliphatique | 29,5 |
| Irgacure 184 | Photoamorceur UV-A | 3,8 |
| Lucirin TPO-L | Photoamorceur domaine visible | 1,0 |

Aussi l'addition de résine tackifiante hydrophobique diminue encore la perméation d'eau.

Egalement, l'addition de résine tackifiante améliore l'adhésion aux structures barrières multicouches.

Tous les tests présentés sur le tableau suivant ont été préparés sur un film barrière multicouche Oike VX 25T-2PO avec une déposition du précurseur d'adhésif par tire-film (bladecoating). Un film barrière Oike est constitué du multicouche suivant : PET 25 microns/couche barrières au gaz/Adhésif/couche barrière aux gaz/PET. La couche barrière aux gaz est une couche mince inorganique d'une épaisseur de l'ordre de 100 nm. Le film utilisé est connu sous la référence VX-25T-2PO commercialisé par la société Oike. Le WVTR est de $3.10^{-4}$ g.m$^{-2}$.j$^{-1}$ d'après la fiche technique de ce produit.

| Adhésif | Adhésion T-pelage aux Films Barrières | | Test de Calcium Optique | |
|---|---|---|---|---|
| | Epaisseur | Adhésion | Epaisseur | Perméation d'eau latérale |
| F18 Formulation liquide sans résine tackifiante | 50 $\mu$m | 1,3 N/cm | 85 $\mu$m | 9,83 $\mu$g/jour |
| | | | 165 $\mu$m | 8,07 $\mu$g/jour |
| S3 Formulation liquide avec résine tackifiante | 50 $\mu$m | 2,6 N/cm | 95 $\mu$m | 6,66 $\mu$g/jour |
| | | | 145 $\mu$m | 5,56 $\mu$g/jour |

Autres exemples de réalisation de la composition de précurseur d'adhésif :

D'autres exemples de précurseurs d'adhésif conformes à l'invention peuvent être préparés par un homme du métier spécialiste de la préparation de précurseurs d'adhésifs en procédant dans un premier temps à une sélection de monomères (métha)cryliques compatibles avec le dispositif électronique à encapsuler.

*1. Choix d'un monomère compatible avec un dispositif électronique souple*

Au delà du choix pertinent des composants de la formulation du précurseur liquide d'adhésif, en fonction des propriétés souhaitées, la formulation à polymériser à l'aide d'une irradiation ultra-violette (UV) doit tenir compte de la compatibilité chimique avec le dispositif à proteger Les monomères, en effet, présentent le plus grand risque de détérioration du dispositif, puisqu'il s'agit de petites molécules qui peuvent agir comme solvants ou réagir chimiquement avec les différentes couches du dispositif et affecter ainsi sa performance. Pour s'assurer que cela n'est pas le cas, des tests préalables de compatibilité chimique peuvent être effectués. Cela a été fait ici, dans le cas d'exemple d'un dispositif consistant en une cellule photovoltaïque organique (cellule OPV) en déposant sur celle-ci dans une boîte à gants à atmosphère d'azote sec, et par une technique de dépôt dite de « spin-coating » (dépôt tournant), les différents monomères des formulations choisies et en mesurant quelque temps après le dépôt (5 et 10 minutes), les courbes caractéristiques densité de courant-tension (J-V) des cellules OPV, afin de déterminer si leurs performances se sont dégradés ou non après dépôt des monomères.

Les cellules OPV testées étaient à architecture inversée et avaient la structure suivant : film de polyéthylène téréphatalate (PET) - couche de oxyde d'étain et indium (acronyme en aglais ITO) - couche de nanoparticules d'oxyde de zinc (Zn0) - couche active de P3HT :PCBM -couche de PEDOT :PSS - couche conductrice d'argent déposée par évaporation. P3HT :PCBM signifie une couche active à base d'une hétérojonction dans la masse (bulk)constituée d'un mélange de poly(3-hexylthiophène)et l'ester méthylique de l'acide phenyl C61 butyrique. PEDOT :PSS est une couche de transport de trous consistant en un mélange de poly(3,4-éthylène di oxy thiophène) et de polystyrène sulfonate. Les monomères ont été déposés par « spin-coating » sur la partie arrière de la cellule, ce qui implique qu'ils sont rentrés en contact avec les couches d'argent et de PEDOT : PSS ; le contact possible avec d'autres couches via une pénétration latérale n'est pas néanmoins à exclure

Les résultats de ce type de test sont montrés dans le tableau ci-dessous et montrent que la plupart des monomères testés sont compatibles chimiquement avec ce type de dispositif, représenté par une cellule OPV à architecture inversée ayant la structure décrite ci-dessus. Seul le monomère SR285 (tetrahydrofurfuryl acrylate) a conduit à une forte dégradation des performances de la cellule OPV, après exposition sur des temps courts. De ce fait et considérant que la conversion du précurseur d'adhésif en l'adhésif polymérisé et éventuellement réticulé prend des temps très courts, inférieurs à 5 s, il a été considéré que tous les monomères testés, pouvaient être utilisés dans les formulations, à l'exception du SR 285.

| Produit | Temps (min) | Tension de circuit ouvert, $V_{oc}$ (mV) | Densité de courant en court circuit, $J_{sc}$ (mA/cm²) | Factor de forme, Fill Factor, FF (%) | Rendement de conversion photonique, PCE (%) | Delta Normalisé de PCE, ΔPCE (%) |
|---|---|---|---|---|---|---|
| SR238 | 0 | 540.5 | 9.61 | 47.53 | 2.47 | --- |
| Cellule 1 | 4 | 541.7 | 8.96 | 48.17 | 2.34 | -5.26 |
| | 10 | 541.6 | 8.85 | 48.18 | 2.31 | -6.48 |
| SR238 | 0 | 553.0 | 9.70 | 51.62 | 2.77 | --- |
| Cellule 2 | 5 | 557.0 | 10.0 | 51.82 | 2.89 | 4.33 |
| | 10 | 561.7 | 9.72 | 51.26 | 2.80 | 1.08 |
| SR285 | 0 | 540.6 | 6.98 | 53.95 | 2.04 | --- |
| Cellule 1 | 6 | 543.7 | 6.45 | 50.99 | 1.79 | -12.1 |
| SR285 | 0 | 549.4 | 9.23 | 52.51 | 2.66 | --- |
| Cellule 2 | 5 | 554.6 | 8.71 | 51.52 | 2.49 | -6.39 |
| | 10 | 553.4 | 8.38 | 51.41 | 2.38 | -10.5 |
| SR484 | 0 | 581.2 | 9.23 | 48.39 | 2.42 | --- |
| Cellule 1 | 4 | 525.5 | 9.51 | 46.59 | 2.33 | -3.72 |
| | 10 | 525.6 | 9.47 | 46.73 | 2.33 | -3.72 |
| SR484 | 0 | 562.3 | 10.0 | 52.00 | 2.93 | --- |
| Cellule 2 | 5 | 556.4 | 10.2 | 53.08 | 3.03 | 3.41 |
| | 10 | 552.8 | 10.2 | 53.94 | 3.04 | 3.75 |
| SR9003 | 0 | 544.8 | 8.22 | 50.81 | 2.28 | --- |
| Cellule 1 | 6 | 547.3 | 8.41 | 50.64 | 2.33 | 2.19 |
| | 10 | 544.5 | 8.43 | 51.16 | 2.35 | 3.07 |
| SR9003 | 0 | 550.8 | 9.87 | 52.76 | 2.87 | --- |
| Cellule 2 | 5 | 553.2 | 10.0 | 52.96 | 2.93 | 2.09 |
| | 10 | 553.0 | 10.0 | 53.23 | 2.96 | 3.14 |

*2. Définitions de formulations de précurseur d'adhésif à partir de monomères identifiés compatibles - Formulation F18*

2.1 Critère d'adhésion au substrat

Sur la base de l'étude de compatibilité chimique, une première formulation, F1, consistant en un mélange de 2 oligomères, 2 monomères et 2 photo-amorceurs a été choisie. Dans cette première formulation, la polymérisation entre deux films de PET ne s'est pas produite, ce qui a conduit à une nouvelle formulation, F2, dans laquelle le ratio massique entre les deux photo-amorceurs a été modifié. Cette formulation a pu polymériser, mais elle ne présentait aucune adhésion au PET, ce qui a conduit à de nouvelles modifications de la formulation. Comme cela peut être déduit du tableau ci-dessous, les formulations F2 à F8 et la formulation F10 présentent des ratios massiques de plus en plus en faveur des monomères et oligomères supposés améliorer l'adhésion à des supports plastiques (CN9002 et SR506D). La formulation F5 a été la première à présenter un peu d'adhésion, même si celle-ci n'a pas été suffisante pour la mesurer par un test de pelage en « T ». Les formulations F6 et F10 ont également montré un peu d'adhésion, mais celle-ci a été à la limite de ce qu'on a pu mesurer à l'aide du test de pelage en « T ». Elles présentaient également un comportement en pelage de type « adhésion-glissement » ou « stick-slip ». Les formulations F12 et F15 incluant des oligomères additionnels sensés promouvoir l'adhésion, ont été testés, mais les résultats décevants ont conduit à leur abandon au profit de la formulation F9.

La formulation F9 comprend presque 90% d'un oligomère dont l'homopolymère est à basse température de transition vitreuse ou Tg (CN131B), le promoteur d'adhésion SR9050, utilisé uniquement dans la formulation F15, puis un ratio différent des deux photoamorceurs. Cette formulation a également présenté une faible adhésion à la limite de détection par le test de pelage en « T » et un comportement de type « stick-slip ». De nouvelles modifications ont été tentées afin d'améliorer l'adhésion par l'utilisation d'oligomères et monomères sensés favoriser ce type d'adhésion, mais aucun bon résultat n'a été obtenu avant la formulation F13 qui a montré une adhésion mesurable par le test de pelage en « T » ; cette formulation présentait, cependant aussi un comportement marqué de type « stick-slip ». Des nouvelles modifications des quantités des monomères et oligomères ont été tentées à partir de la formulation F13, dans l'espoir de diminuer le comportement de type « stick-slip », ce qui a fini par conduire à la formulation F18 qui montrait la meilleure adhésion et le plus faible caractère de type « stick-slip » à l'arrachage.

| | F1 | F2 | F3 | F4 | F5 | F6 | F7 | F8 | F10 | F12 | F15 |
|---|---|---|---|---|---|---|---|---|---|---|---|
| CN131B Oligomère à basse Tg d'homopolymère | -- | -- | -- | -- | -- | -- | -- | -- | -- | 10.7% | 10.1% |
| CN9001 Oligomère à Tg d'homopolymère moyenne | 20.9% | 21.1% | 10.5% | 10.5% | 10.5% | 5.2% | 8.9% | 4.0% | -- | -- | -- |
| CN9002 Oligomère à très basse Tg d'homopolymère | 20.9% | 21.1% | 31.4% | 31.4% | 31.4% | 36.6% | 62.4% | 27.3% | 42.5% | 31.9% | 30.2% |
| SR238 Monomère diacrylate | 31.4% | 31.8% | 31.2% | 21.0% | 10.4% | 10.5% | 4.7% | 12.6% | -- | -- | -- |
| SR506D Monomère mono acrylate | 21.3% | 21.2% | 21.1% | 31.4% | 41.9% | 41.9% | 19.1% | 50.0% | 51.9% | 52.1% | 49.2% |
| SR9050 Promoteur d'adhésion | -- | -- | -- | -- | -- | -- | -- | -- | -- | -- | 5.4% |
| Irgacure 184 Amorceur UV-A | 4.8% | 2.4% | 2.9% | 2.9% | 2.9% | 2.9% | 2.4% | 3.1% | 2.8% | 2.6% | 2.6% |
| TPO-L Amorceur domaine visible | 0.6% | 2.4% | 2.9% | 2.8% | 2.9% | 2.9% | 2.4% | 3.1% | 2.8% | 2.6% | 2.6% |
| Résultats test adhésion | Pas polymérisé | Aucune adhésion | Aucune adhésion | Aucune adhésion | Sous la limite de détection | A la limite de détection, « stick-slip » | Aucune adhésion | Aucune adhésion | A la limite de détection, « stick-slip » | A la limite de détection, « stick-slip » | A la limite de détection, « stick-slip » |

| | F9 | F11 | F13 | F14 | F16 | F17 | F18 |
|---|---|---|---|---|---|---|---|
| CN131B Oligomère à basse Tg d'homopolymère | 89.5% | 89.3% | 67.0% | 44.8% | 78.3% | 55.9% | 61.6% |
| CN9002 Oligomère à très basse Tg d'homopolymère | -- | -- | 22.3% | 44.6% | 11.2% | 33.6% | 28.0% |
| SR9050 Promoteur d'adhésion | 5.6% | -- | 5.7% | 5.7% | 5.7% | 5.7% | 5.6% |
| SR506D Monomère monoacrylate | -- | 5.8% | -- | -- | -- | -- | -- |
| Irgacure 184 Amorceur UV-A | 3.8% | 3.8% | 3.8% | 3.8% | 3.7% | 3.8% | 3.8% |
| TPO-L Amorceur domaine visible | 1.1% | 1.1% | 1.1% | 1.1% | 1.0% | 1.0% | 1.0% |
| Résultats test adhésion | A la limite de détection, « stick-slip » | A la limite de détection, « stick-slip » | 1.46 N/cm "Stick-slip" | 0.74 N/cm | 1.97 N/cm "Stick-slip" | 1.28 N/cm | 1.32 N/cm |

2.2 Faculté du précurseur d'adhésif à polymériser par irradiation UV entre deux films barrière

La capacité du précurseur liquide d'adhésif à polymériser et éventuellement réticuler pour se transformer en l'adhésif de l'invention a été testée, grâce à l'utilisation de l'analyse spectroscopique infrarouge à transformée de Fourier (FTIR) en configuration de réflexion totale atténuée (ATR), sur des échantillons après pelage. Conformément à ce qui est décrit dans la littérature scientifique pour ce type d'analyses, les calculs se sont basés sur la comparaison des surfaces sous la courbe des pics à c. 830 cm$^{-1}$ (dorsale époxy) et à 810 cm$^{-1}$ flexions hors plan des motifs C-H sur RCH=CH2.

La formulation F18 a présenté une forte inhibition de la polymérisation par l'oxygène nécessitant la réalisation de l'étape de conversion UV entre deux feuilles de substrat plastique, lorsque la conversion est effectuée en dehors d'une boîte à gants à atmosphère contrôlée (conversions en atmosphère d'air). Ce mode de conversion entre deux substrats est préféré aussi puisqu'il correspond à ce qui est fait lors des processus d'encapsulation de dispositifs. Des tests ont été effectués utilisant soit des substrats plastiques de PET (50 microns d'épaisseur), soit des films barrière Oike VX 25T-2PO, puisque ces deux films plastiques ont des spectres de transmission lumineuse différents. Les deux types de lampes (mercure basse pression) et à LED ont également été essayés. Quelque soit le procédé de conversion utilisé, la conversion de la formulation F18 a été réalisée en un temps court conformément à la figure 4. Pour s'assurer que tous les échantillons soient bien convertis, des temps d'exposition de 30 secondes ont été utilisés.

*3. Définitions de formulations de précurseur d'adhésif à partir de monomères identifiés compatibles - Formulation S3*

Un autre adhésif a été formulé utilisant une procédure de sélection similaire à celle conduisant à la formulation F18. Le but a été d'améliorer l'adhésion de la formulation F18. Cela a été obtenu en remplaçant les deux oligomères de la formulation F18 par une composition d'oligomère et monomère différente. Le monomère a également été testé en compatibilité chimique avec des cellules OPV. En même temps, la résine tackifiante aliphatique et non réactive Norsolene S95 a été ajoutée à la formulation pour promouvoir davantage l'adhésion. L'adhésif résultant, baptisé S3, de formulation présentée dans le tableau ci-dessus a présenté une force d'adhésion de 3,01 N/cm en test de pelage en « T » sur du PET, ce qui est largement supérieur aux 1,32 N/cm de la formulation F18.

*4. Définitions de formulations de précurseur d'adhésif à partir d'autres monomères/oligomères*

L'adhésif liquide de l'invention comprend au moins un oligomère insaturé et au moins un photo-initiateur.

L'oligomère insaturé est tel qu'il possède au moins un groupe réactif (polymérisable) par molécule choisi parmi les fonctions (méth)acryl. Ainsi typiquement, les monomères et oligomères utiles pour l'invention sont choisis parmi des molécules mono, di, tri ou polyfonctionnelles ayant une masse moléculaire comprise entre 30 et 30000 daltons.

On peut ainsi citer comme exemples de fonctions réactives dans les oligomères, les fonctions (méth)acrylate d'alcool tel que :

éthanol, propanol, isopropanol, butanol, isobutanol, hexanol, méthyl pentanol, iso-octanol, n-octanol, 2-éthylhexanol, iso-décanol, n-décanol, alcool laurylique, tridécyl alcool, tetradécyl alcool, cétyl alcool, stéaryl alcool, alcool béhénylique, cyclohexyl alcool, 3,3,5-triméthyl cyclohexyl alcool, triméthylolpropane formal cyclique, 2-phénoxy éthanol, nonyl phénol, isobornol et esters (métha)cryliques de diols et polyols tels que l'ethylène glycol, propylène glycol, 1,3-propane diol, 1,3-butane diol, 1,4-butane diol, 1,6-hexanediol, 3-méthyl-1,5-pentanediol, 1,9-nonanediol, 1,10-décanediol, 1,12-dodécanediol, 1,4-cyclohexanediméthanol, tricyclodécanediméthanol, néopentyl glycol, triméthylol propane, glycérol, tris(hydroxyéthyl)isocyanurate, pentaerythritol, ditriméthylolpropane, di-pentaerythritol et les dérivés alcoxylés ou modifiés par de la caprolactone de ces alcools, diols et polyols, dipropylène glycol, tripropylène glycol et des glycols supérieurs de propylène, diéthylène glycol, triéthylène glycol, tetraéthylène glycol et des glycols supérieurs d'éthylène, des glycols mixtes d'éthylène/propylène des dérivés alcoxylés de bisphénol A

Ou d'autres exemples de (méth)acrylates :

diacrylate de méthacrylate de glycidyle, mono,di ou poly(méth)acrylate de glycidyle, Diacrylate de glycidyl methacrylate, di(méth)acrylate de glicydile, mono,di ou poly (méth)acrylates d'alcool allylique, ou d'alcool allylique alcoxylé, mono, di ou poly (méth)acrylate d'alcool vinylique mono, di ou poly (méth)acrylates d'hydroxyalkyl (méth)acrylates, triméthylol propane triacrylate éthoxylé (TMPTA éthoxylé), glycérol tri(méth)acrylate ou di(méth)acrylate, triméthylol propane tri(méth)acrylate (TMPTA ou TMPTMA), hexanediol di(méth)acrylate, bisphénol A diacrylate, phénoxy éthyl (méth)acrylate, mono, di ou poly (méth)acrylate de nonyl phénol éthoxylé.

Plus particulièrement, on peut citer comme exemples d'oligomères :

époxy (meth) acrylates, tels que ceux dérivés d'un éther choisi parmi le groupe consistant en bisphénol A diglycidyl éther 1 ,4-butanediol diglycidyl éther ou polypropylène glycol diglycidyl éther, uréthane (méth)acrylates tels que ceux dérivés d'un isocyanate choisi parmi le groupe consistant en toluène diisocyanate, methylène diphényl diisocyanate méthylène diphényl di-isocyanate hydrogéné, isophorone diisocyanate, hexaméthylène diisocyanate, triméthyl hexaméthylène diisocyanate en combinaison avec un composé à hydrogènes actifs choisi parmi le groupe consistant en un polyester, polyéther ou polycarbonate polyol; hydroxyalkyl(méth)acrylate, tel que hydroxyéthyl(méth)acrylate ou polycaprolactone (méth)acrylate ; et des polyester acrylates dérivés de composés di ou poly-hydroxy et de composés fonctionnels des acides di ou poly-carboxyliques.

Les oligomères peuvent également être des (méth)acrylates dendritiques à haute fonctionnalité tels que ceux commercialisés par Sartomer (groupe Arkema), comme CN2301, CN2302, CN2303 et CN2304.

Il peut s'agir également d'oligomères (méth)acryliques (méth)acrylés multifonctionnels dérivés glycidyl (méth)acrylate de glycidyle, tels que ceux dérivés de l'acrylation partielle ou totale par de l'acide (méth)acrylique des groupes époxy d'un copolymère du (méth)acrylate de glycidyle avec au moins un autre monomère (méth)acrylique, comme par exemple, un oligomère (méth)acrylé du méthyl méthacrylate copolymérisé avec du méthacrylate de glycidyle.

Parmi les monomères et oligomères pouvant être utilisés pour l'invention, on peut aussi citer les monomères ou oligomères commercialisés par Sartomer (groupe Arkema) tels que ceux présentés dans les tableaux précédents.

**Contrôle de la Tg du polymère adhésif obtenu suite à la polymérisation / réticulation du précurseur**

La température de transition vitreuse (Tg) du polymère réticulable par irradiation est de préférence dans la plage comprise entre -60 et +10° C, plus particulièrement dans la plage comprise entre -60 et 0° C, ou entre -55° C et -10° C, et plus de préférence entre -55° C et -20° C. La température de transition vitreuse peut être déterminée par des procédés habituels, tels que l'analyse thermique différentielle ou l'analyse calorimétrique différentielle (DSC). S'agissant de la DSC, il est bien connu de l'homme de l'art que des transitions vitreuses sont repérées par l'intermédiaire de cette technique, sous la forme de courbes en « S » ou « S » inversée (selon la convention utilisée) lors des balayages ascendants en température, à vitesse de balayage constante (généralement à 10°C/min) qui fournissent des thermogrammes ou courbes de DSC où, le plus souvent, le flux de chaleur (heat flow) est représenté en fonction de la température ; il est également connu de l'homme de l'art que ces « S » ou « S » inversées présentent trois points d'inflexion (le premier à la température la plus basse, correspondant au début de la transition vitreuse, le point intermédiaire, et le dernier à la température la plus haute, correspondant à la fin de la transition vitreuse). Les valeurs données ci-dessus pour la Tg correspondent à celles obtenues à partir du premier point d'inflexion (temperature la plus basse, dans un balayage en montée de température) de la courbe de flux de chaleur (Heat Flow) en function de la temperature.

L'équation désignée équation de Fox permet à l'homme du métier d'identifier, au préalable, des copolymères dans la plage Tg correspondante, et de les préparer spécifiquement en faisant varier de manière appropriée la nature et la quantité de monomères. Selon Fox (T. G. Fox, Bull. Am. Phys. Soc. 1956 [Ser. II] 1, page 123, et conformément à la Ullmann's Encyclopädie der technischen Chemie, vol. 19, page 18, 4e édition, Verlag Chemie, Weinheim, 1980), la température de transition vitreuse des copolymères avec des niveaux faibles de réticulation, est donnée avec une bonne approximation par :

$$\frac{1}{T_g} = \frac{x^1}{T_g{}^1} + \frac{x^2}{T_g{}^2} + \cdots + \frac{x^n}{T_g{}^n}$$

où $x^1$, $x^2$, ... $x^n$ sont les fractions massiques des monomères 1, 2, ... n et $Tg^1$, $Tg^2$, ... $Tg^n$ sont les températures de transition vitreuse des polymères synthétisés uniquement à partir des monomères 1, 2, dans chaque cas... n (homopolymères), en degrés Kelvin. Les valeurs Tg pour les homopolymères de la majorité des monomères sont connues et listées, par exemple, dans la Ullmann's Encyclopedia of Industrial Chemistry, vol. A21, page 169, 5e édition, VCH Weinheim, 1992 ; d'autres sources de températures de transition vitreuse d'homopolymères peuvent également être consultées dans J. Brandrup, E. H. Immergut, Polymer Handbook, 1re edition, J. Wiley, New York 1966, 2e edition, J. Wiley, New York 1975, et 3e édition, J. Wiley, New York 1989).

Cette équation de Fox ne pourra être utilisée que comme un guide pour débuter une formulation d'autant que les adhésifs selon l'invention ne sont pas forcément dans une situation de faible taux de réticulation, mais plutôt bien au contraire, dans une situation de taux de réticulation relativement élevé.

**Exemple de procédé de préparation des compositions de précurseur**

Les adhésifs acrylates durcissant aux UV ont tous été fournis sous forme de monomères, oligomères ou mélanges de monomères, oligomères et additifs. Il a donc été nécessaire de réaliser les formulations avant utilisation, en mélangeant ces matériaux dans les rapports appropriés avec des photo-initiateurs.

Les solutions ont été mélangées dans des bouteilles ou des flacons en verre, par agitation magnétique. Les composants ont été mesurés par masse et ajoutés directement à la solution principale. Il en a été ainsi en raison de la tendance pour nombre de monomères et d'oligomères à laisser une quantité de résidus sur les récipients et dispositifs de mesure avec lesquels ils étaient en contact. Les oligomères à viscosité très élevée ont toujours été ajoutés en premier à l'aide d'une spatule, suivis des monomères et oligomères restants dont la précision a été obtenue par addition au goutte à goutte. Sans que la solution puisse toujours être totalement mélangée, elle pouvait l'être au moins partiellement avant l'addition des photo-initiateurs. Une fois les photo-initiateurs ajoutés, les solutions ont pu être complètement mélangées par agitation magnétique. Plusieurs formulations présentaient une viscosité trop élevée pour être agitées. Pour ces solutions, la plaque d'agitation magnétique a été chauffée à 60°C afin de réduire la viscosité de la solution et permettre un mélange complet. Cette technique de chauffage a également été utilisée lorsque ces solutions devaient être déposées avec une pipette, pour en faciliter la manipulation. L'absence de changements de l'indice de réfraction et de particules a permis de vérifier visuellement l'homogénéisation du mélange.

Pour certains échantillons il a été nécessaire d'utiliser les adhésifs placés à l'intérieur d'une boîte à gants sous atmosphère inerte. Puisque les matières premières et les solutions ont été préparées à l'air libre, l'oxygène et l'eau ont été éliminés par barbotage dans l'azote sec pendant une nuit. Les solutions ont ensuite été immédiatement fermées hermétiquement dans leur bouteille en verre, sous azote sec, et placées dans la boîte à gants. Cette procédure a été utilisée dans la mesure où les composants volatils de ces solutions auraient pu être perdus avec un procédé de dégazage sous vide.

**Exemple de procédé d'encapsulation, de laminage**

Les substrats ont d'abord été découpés à la taille approximative de l'échantillon final. Comme pour le laminage des PSA, il peut se révéler difficile d'obtenir un alignement parfait pendant l'opération ; on a donc jugé plus simple et plus précis de découper l'échantillon à ses dimensions correctes après laminage. Les substrats ont été traités en surface comme souhaité (rinçage au solvant, sonication dans un solvant, traitement corona), puis séchés dans une étude à vide à 80°C/1-5mbar, pendant deux jours, opération suivie d'un refroidissement à 30°C, toujours sous vide. Les substrats ont été ensuite rapidement placés dans la boîte à gants. puis revêtus d'adhésif à l'intérieur de la boîte, comme décrit précédemment. L'objet à encapsuler a été immédiatement laminé sur un substrat revêtu manuellement d'adhésif. Un second substrat revêtu d'adhésif a ensuite été laminé au-dessus, toujours manuellement.

L'échantillon laminé a été durci par la suite, comme l'exigeait l'adhésif, tel qu'expliqué ci-dessous. Puis, l'échantillon a été retourné et durci pendant un second cycle complet, pour garantir le durcissement correct des zones inférieures de l'objet encapsulé.

### Exemple d'étape de polymérisation des compositions

Cette classe d'adhésif nécessite également l'étape additionnelle de durcissement à la lumière ultraviolette entre les substrats.

Le durcissement des adhésifs (meth)acryliques durcissant aux UV a été réalisé à l'aide de deux lampes différentes. Les paramètres de durcissement ont été confirmés pour chaque lampe séparément, mais, une fois validées, les deux lampes ont été employées de manière interchangeable et considérées comme procurant un durcissement équivalent. L'analyse infrarouge à transformée de Fourrier ( acronyme anglais FTIR) par réflexion totale atténuée (acronyme anglais ATR), FTIR-ATR, a permis de suivre l'effet des paramètres de durcissement. Ces paramètres comprennent la durée d'éclairage, la distance par rapport à la lampe, l'intensité de celle-ci et le type d'atmosphère.

Une lampe au mercure à pression moyenne, Hönle UVASPOT 400/T-F, avec filtre à quartz, a été utilisée pour le durcissement à l'air libre, et placée dans une hotte ou une paillasse ventilée. Cette lampe produit un large spectre de longueurs d'onde, allant d'environ 200 à 600 nm. Bien que l'intensité de cette lampe ne puisse être réglée, la diminution de la distance entre cette dernière et l'échantillon, augmente l'intensité sur celui-ci.

La seconde lampe UV, utilisant une source à diodes électroluminescentes LED, a été placée à l'intérieur d'une boîte à gants à atmosphère inerte. Cette lampe, DELOLUX 20/400, produisait un spectre étroit de longueurs d'onde, avec un pic à ~400nm. La structure supportant cette lampe ne permettait pas de changer la distance entre elle et l'échantillon, mais, l'unité de commande autorisait le réglage de la puissance fournie par la lampe (et donc, son intensité).

### Photo-initiateurs ou activateur

Deux photo-initiateurs différents ont été utilisés pour lancer la réaction de polymérisation par radicaux des adhésifs acryliques durcissant aux UV.

l'Irgacure 184 de Ciba Specialty Chemicals, aujourd'hui BASF, est une poudre de 1-hydroxy-cyclohexyl-phényl-cétone, photo-initiateur radicalaire activé principalement dans le spectre UVA.

Le lucirine TPO-L de BASF est un photo-initiateur liquide, activé par des longueurs d'onde de lumière plus longues que celles de l'Irgacure 184, consistant en de l'éthyl-2,4,6-triméthylbenzoylphénylphosphinate.

Une liste non exhaustive de photo-amorceurs est donnée ici, à titre d'exemple :
La 2-hydroxy-2-méthyl-1-phényl-propan-1-one, le 2,4,6-triméthylbenzoyl-diphényl-phosphineoxyde, la 1-hydroxy-cyclohexyl-phényl-cétone, le bis(2,6-diméthoxybenzoyl)-2,4,4-triméthyl-pentyl phosphine oxyde, la 1-[4-(2-hydroxyéthoxy)-phényl]-2-hydroxy-2-méthyl-1-propane-1-one, la 2,2-diméthoxy-1,2-diphényléthan-1-one et la 2-méthyl-1[4-(méthylthio)phényl]-2-morpholinopropan-1-one, sont des exemples non limitatifs dudit au moins un photo-initiateur.

Dans certains modes de réalisation, ledit au moins un photo-initiateur est réactif dans les spectres UV et visible. Dans certains autres modes de réalisation, ledit au moins un photo-initiateur, activé par la lumière dans le spectre visible, permet le durcissement lorsque la lumière passe à travers le verre ou d'autres couches de protection filtrant les UV. Les oxydes de phénylphosphine, tels que l'Irgacure 184, fabriqué par Ciba, et aujourd'hui, par BASF, et le Lucirine TPO, fabriquée par BASF, sont des exemples non limitatifs de tels photo-initiateurs.

### Nanoparticules

Des nanoparticules capables d'avoir un effet de diminution de la perméation à l'eau peuvent être incorporées au précurseur d'adhésif, dans une teneur de préférence comprise entre 3 et 20% en poids.

Ces nanoparticules comprennent des particules extra-fines présentant une structure lamellaire définissant des couches d'une taille inférieure ou égale à 20 microns, de préférence inférieure ou égale à 10 microns, de préférence, inférieure ou égale à 6 microns, telles que des phyllosilicates, de préférence la Cloisite 10A et/ou la Cloisite 15A ; et/ou sont sensiblement sphériques et présentent un diamètre moyen inférieur ou égal à 1 micron, de préférence inférieur ou égal à 300 nm, de préférence inférieur ou égal à 100 nm, de préférence inférieur ou égal à 60 nm telles que des zéolites naturelles synthétiques et/ou artificielles, de préférence des zéolites de structure Linde Type L (LTL). Ces nanoparticules peuvent comprendre également des particules extrafines d'un matériau absorbant, telles que des particules de polyacrylate de sodium réticulé, et présenter par exemple des tailles inférieures à 100 microns, de préférence à 10 microns, de préférence à 1 micron, de préférence à 500 nm, de préférence à 50 nm.

**Résultats expérimentaux obtenus:**

Propriétés thermo-mécaniques

*Tg*

Il est préférable qu'il n'y ait pas de transtion principale dans la plage d'utilisation du dispostif encapsulé de façon à ne pas générer des problèmes mécaniques lors de l'utilisation. Aussi, apporte-t-on un soin particulier dans le choix des monomers/oligomers constitutifs du précurseur d'adhésif pour garantir l'obtention d'une Tg n'impliquant pas de transition de phase lors de l'utilisation du dispositive encapsulé, ce qui est notamment le cas de la formulation F18 :

La figure 5 représente la courbe DMTA de F18, dans un essai réalisé avec une rampe montante de température de 3°C/min, à une fréquence fixe de 1Hz et à une déformation maximale fixe de 0,1%. L'adhésif a présenté un comportement typique d'un polymère réticulé, avec une transition vitreuse claire et un plateau caoutchoutique montrant une augmentation légère et progressive du module de conservation au-dessus de la Tg. La figure 5 présente la chute rapide du module de perte, en dessous de la limite de détection de l'équipement, en raison de la montée vers des températures plus élevées. Aux fins de la présente invention, F18 est suffisamment flexible, mais l'augmentation de sa rigidité à des températures plus froides laisse craindre des problèmes pour son utilisation dans l'encapsulation actuelle des dispositifs OPV, qui peuvent être exposés à des températures hivernales à l'extérieur. Une version légèrement plus souple de cet adhésif peut être nécessaire si le produit final est soumis à des conditions climatiques plus froides.

| Adhésif | Pic E" DMTA |
|---------|-------------|
| F18 | -20°C |

*Adhérence*

Un essai d'adhésion additionnel a également été réalisé sur ces adhésifs, en utilisant des substrats comme films barrières. Bien que l'adhérence de F18 soit identique à celle des films PET et Oike VX 25T-2PO, celle de S3 a enregistré une forte baisse, comparée aux substrats PET (voir figure 10). Bien qu'il n'était pas possible de procéder à des mesures quantitatives, en raison d'une convolution de pic, une comparaison relative des pics FTIR-ATR, illustrée sur la figure 6, a montré que les échantillons utilisant des substrats Oike n'étaient pas entièrement durcis. Il a été remédié à cette anomalie en augmentant la durée d'exposition et l'intensité de la lampe UV, ce qui a permis à l'adhésif de retrouver une partie de son adhérence. On notera également qu'après l'essai d'adhérence, S3 a affiché une forte adhésivité et un caractère PSA (pour adhésif sensible à la pression dans son acronyme anglais, voulant dire un adhésif présentant du « tack » ou pégosité aux doigts), dus, vraisemblablement, à son module et sa température de transition vitreuse (Tg), faibles. Le film F18 n'a cependant montré pratiquement aucune pégosité, en restant intact après l'essai d'adhérence. L'adhérence n'était pas particulièrement forte pour les adhésifs durcissant aux UV, en particulier, F18. Les essais d'adhérence pratiqués sur les substrats traités par effet corona ont également été réalisés comme procédé d'augmentation de l'adhérence.

*Transparence*

Pour évaluer la transparence des adhésifs, une spectroscopie UV-Vis a été réalisée, et les résultats présentés sur la figure 8. Les échantillons ont tous été durcis entre deux substrats PET. Puisque l'on sait que les deux adhésifs présentent un défaut d'adhérence à l'interface PET, on les a détachés pour produire un revêtement d'adhésif sur un film PET unique. Le film PET a été placé face à la source laser, pour que la réflexion sur les échantillons soit identique. Les deux échantillons révèlent une absorption supérieure, aux longueurs d'onde inférieures, à celle du PET non revêtu, S3 étant particulièrement moins transparent, à ces longueurs d'onde plus courtes. Cela n'est pas surprenant, car S3 est de couleur jaune-orange dans les couches très épaisses, bien qu'il apparaisse clair à l'oeil, dans les couches de dix microns. Cette couleur provient essentiellement de la résine tackifiante, créant, de ce fait, un compromis entre adhérence et clarté optique.

*Perméation*

La perméation de vapeur d'eau des deux adhésifs acryliques durcissant aux UV a été étudiée, en utilisant un essai dit « au calcium optique », décrit dans la publication n° IPCOM000242078D, citée ci-dessus, postée sur le site ip.com. La figure 9 montre la perméation latérale apparente, mesurée pour chaque échantillon.

Sur la figure 9, on peut voir que S3 présente une perméation interfaciale inférieure, comparé à F18.

Des échantillons ont également été préparés à l'aide de films barrières traités par effet corona, pour les deux adhésifs. F18 et S3 se caractérisant principalement par une perméation interfaciale, il est important d'améliorer l'interface. Les traitements par effet corona étaient destinés à améliorer l'adhérence des deux adhésifs, et à limiter la perméation latérale dans les essais au calcium optique. La relation entre la force d'adhérence et le taux de perméation latérale à l'eau, de l'échantillon traité par effet corona, coïncide avec la tendance relevée pour les échantillons non traités par ce procédé, comme on peut le constater sur la figure 9BIS.

*Encapsulation*

En plus de leur caractérisation, les adhésifs et les nanocomposites ont également été soumis à des essais d'encapsulation de dispositifs photovoltaïques, organiques et fonctionnels (OPV), en les soumettant à des conditions de vieillissement accélérées. Le but final du développement des matériaux dans la présente invention étant l'encapsulation de dispositifs flexibles, cet essai permet de démontrer la possibilité ou non desdits matériaux, à être mis en œuvre pour l'usage auquel ils sont destinés, en prenant comme exemple celui des cellules OPV. Cet essai autorise également une comparaison des résultats de perméation d'eau des essais au calcium optique avec le vieillissement de dispositifs OPV actuels en environnements humides. Trois études différentes ont été réalisées dans la présente invention à l'aide de plusieurs schémas d'encapsulation pour soumettre des adhésifs à des essais.

Les essais ont tous utilisé des cellules OPV à structure inversée, et fabriquées de la même manière. La Figure 2 illustre l'architecture exacte des cellules avec l'image d'un dispositif complet avant encapsulation. Les cellules consistaient en un substrat de PET de 17 mm x 25 mm x 175 $\mu$m, avec un oxyde conducteur transparent (acronyme en anglais TCO) sur une surface. Des plages en chrome revêtues d'or ont été ensuite déposées séquentiellement par dépôt physique en phase vapeur par évaporation, aux extrémités des substrats, pour permettre le contact des électrodes lors de la mesure de la cellule terminée. La couche de transport d'électrons (acronyme en anglais ETL) était constituée de nanoparticules d'oxyde de zinc recouvertes par dépôt centrifuge en atmosphère ambiante, à partir d'une suspension dans l'éthanol. La couche active présentait une structure à hétérojonction de poly(3-hexylthiopène) (P3HT), comme absorbeur, et un ester méthylique d'acide phényl $C_{61}$ butyrique (PCBM), comme accepteur d'électrons. Cette couche active a été appliquée par dépôt centrifuge sur l'ETL, à partir d'une solution dans le dichlorobenzène, à l'intérieur d'une boîte à gants en atmosphère inerte. La couche de transport de trous (acronyme en HTL), consistant en du poly(3,4-éthylènedioxythiophène) mélangé avec du poly(styrène sulfonate) (PEDOT:PSS), a été déposée par centrifugation sur la couche active dans l'air, à partir d'une solution aqueuse. Une électrode inférieure en argent a finalement été appliquée par dépôt physique en phase vapeur par évaporation, de manière à créer deux cellules par substrat.

Les cellules ont ensuite été mesurées par caractérisation J-V et stockées à l'intérieur d'une boîte à gants en atmosphère inerte. Seules les cellules présentant de bonnes performances en caractérisation J-V ont été utilisées dans les études d'encapsulation.

Le vieillissement accéléré a été effectué selon la norme ISOS-D-3, à une température de 65°C et une humidité relative de 85%, sans éclairage.

Les schémas d'encapsulation présentant différents avantages et inconvénients, plusieurs d'entre eux ont été pris en compte pour les essais de la présente invention.

Les fils de sortie des connexions électriques, souvent à l'origine d'autres chemins de perméation, ont été évités dans la mesure du possible.

*« encapsulation directe », figure 3a*

Une solution au problème consistait à encapsuler entièrement les cellules sans fils de sortie ou connexions électriques. Pour mesurer les cellules, le film barrière peut être ouvert en le coupant sur les électrodes. Pour protéger le dispositif du scalpel, utilisé pour couper le film barrière, et du grattage nécessaire pour enlever l'adhésif résiduel, un ruban d'interconnexion 3M Charge-Collecting Solar Tape 3307 a été placé sur les électrodes avant encapsulation. Ce processus destructif implique que chaque dispositif ne peut être mesuré qu'une seule fois après encapsulation, ce qui élimine la possibilité par la suite de mesurer les cellules encapsulées et suivre le vieillissement d'une cellule unique à intervalles de temps prédéterminés. Ce schéma sera désormais désigné comme encapsulation "directe".

*« encapsulation par électrode ouverte, figure 3B*

Une autre solution permettant d'éviter les fils de sortie consiste à laisser les électrodes non encapsulées. Ce schéma permet une mesure répétée et facile des cellules, mais également de moins surveiller les distances entre le bord de l'encapsulation et la cellule. Cela peut également conduire à exposer la couche hygroscopique PEDOT:PSS à l'air, dans certaines régions extérieures à l'encapsulation, fournissant un chemin potentiel à la perméation de la vapeur d'eau. Ce schéma sera désormais désigné comme encapsulation "par électrode ouverte".

*« encapsulation par ruban, figure 3C*

Un dernier schéma d'encapsulation , utilisé dans la présente invention, consiste en un ruban d'interconnexion 3M Charge-Collecting Solar Tape 3307, servant à raccorder les deux cellules en parallèle, puis à sortir de l'encapsulation. Ce schéma assure un bon contrôle des distances entre le bord de l'encapsulation et la cellule, et permet une mesure répétée et facile des cellules, même si cela occasionne un problème de sortie de connexions électriques de l'encapsulation, évoqué précédemment. Ce schéma, présenté sur la figure 3c, sera désigné comme encapsulation "par ruban".

*Propriétés électroniques*

L'importance de la variation entre les cellules relevées dans la présente étude, rend difficile l'identification de tendances parmi les adhésifs, et notamment, pour les adhésifs à base de F18. Néanmoins, il est possible de procéder à des comparaisons, en particulier, avec les cellules les plus performantes pour chaque condition d'essai. La perte de rendement de conversion photonique (acronyme en anglais) PCE dans toutes les cellules a été reflétée étroitement par une perte du courant de court-circuit, alors que la tension de circuit ouvert et le facteur de forme (FF pour l'acronyme en anglais de Fill Factor) sont restés relativement stables. Certaines cellules ont montré une perte progressive de leur FF, bien que moins importante que celle du courant de court-circuit, et n'apparaissant pas tant que la PCE de la cellule n'a pas fortement diminué. Comme l'illustre la figure 11, une épaisseur de 150 microns de F18 a permis l'obtention de performances satisfaisantes et de taux lents de perte de PCE. Cela concorde généralement avec les résultats de la perméation d'eau relevés lors de l'essai au calcium optique, où F18 a affiché un taux inférieur de perméation latérale apparente à la vapeur.

*Vieillissement*

Le vieillissement accéléré des dispositifs OPV encapsulés à 65°C et 85% d'humidité relative et stockés dans un endroit sombre, a fourni un éclairage supplémentaire sur les propriétés barrières de F18. Le F18 pur a montré généralement des pertes lentes de PCE. Les performances de F18, malgré des résultats variables dans le vieillissement de dispositifs OPV, semblent appropriées pour son utilisation dans l'encapsulation de dispositifs OPV flexibles, en fonction des résultats du vieillissement accéléré à l'humidité, dans des endroits sombres.

**Procédés de vieillissement utilisés**

Des conditions accélérées artificielles ont été retenues pour les expériences exigeant un vieillissement, afin de réduire la durée de l'essai et de garantir des conditions constantes pour tous les échantillons.

**Par humidification**

Les essais de vieillissement accéléré à l'humidité ont été menés à 65°C et 85% d'humidité relative, indépendamment du type d'échantillon. Ces conditions ont été sélectionnées, car elles correspondent à la norme ISOS-D-3, qui utilise les mêmes conditions que celles décrites ci-dessus, pour le vieillissement à la chaleur humide de dispositifs photovoltaïques organiques, sans éclairage. Ces conditions ont été produites dans une chambre humide, en utilisant soit un Dycometal CM-25/48 soit un Clima Temperatur Systeme C-40/100. Les échantillons ont été placés sur des étagères à grilles métalliques dans les deux chambres.

**Revendications**

**1.** Procédé d'encapsulation d'un dispositif électronique flexible avec au moins une feuille flexible de protection contre la perméation orthogonale aux gaz, par l'intermédiaire d'un adhésif de protection contre la perméation latérale aux gaz, le procédé comprenant :

- une étape d'application d'une couche d'un précurseur polymérisable d'adhésif de protection contre la perméation latérale aux gaz, sur la surface du dispositif et/ou sur la surface de la feuille flexible de protection aux gaz, le précurseur d'adhésif comprenant des oligomères à double liaisons réactives de type (meth)acryliques, et un amorceur de polymérisation,
- puis, une étape de polymérisation du précurseur d'adhésif appliqué, alors qu'il se retrouve disposé entre le dispositif et la feuille de protection aux gaz, afin de constituer l'adhésif solidarisant la feuille de protection au dispositif tout en protégeant le dispositif de la perméation latérale aux gaz.

2. Procédé selon la revendication 1, dans lequel le précurseur d'adhésif présente à l'état non polymérisé, lors de l'application sur la surface du dispositif et/ou sur la surface de la feuille flexible de protection aux gaz, une viscosité dynamique comprise entre 10-3 et 101 Pa.s pour un taux de cisaillement de 1 s$^{-1}$ de préférence entre 10 mPa.s à 100 000 mPa.s pour un taux de cisaillement de 1 s$^{-1}$, avantageusement entre 50 mPa.s et 75 000 mPa.s pour un taux de cisaillement de 1 s$^{-1}$.

3. Procédé selon la revendication 1 ou 2, dans lequel le précurseur d'adhésif est polymérisable par irradiation UV.

4. Procédé selon l'une des revendications précédentes, dans lequel la couche de précurseur d'adhésif est appliquée à l'état non polymérisé sur une épaisseur prédéterminée, permettant de doter l'adhésif formé après polymérisation, d'une épaisseur inférieure ou égale à 3000 microns, de préférence inférieure ou égale à 150 microns.

5. Procédé selon l'une des revendications précédentes, dans lequel le précurseur d'adhésif comprend des monomères (meth)acryliques, de préférence un acrylate de alkyl-phénol éthoxylé, et les oligomères sont fonctionnalisés avec des groupes (meth)acryliques.

6. Procédé selon l'une des revendications précédentes, dans lequel l'oligomère à doubles liaisons réactives est choisi parmi la famille des époxy (meth)acrylate aromatiques, des (meth)acrylates aliphatiques difonctionnels ou un mélange de ceux-ci ou dans lequel l'oligomère à doubles liaisons réactives est un oligomère comprenant un diacrylate uréthane aliphatique et 10% de 2-(2éthoxy éthoxy) éthyl acrylate.

7. Procédé selon l'une des revendications précédentes, dans lequel l'amorceur de polymérisation est choisi parmi le 2-hydroxy-2-methyl-1-phenyl-propan-1-one, 2,4,6-trimethylbenzoyl-diphenyl-phosphineoxide, 1-hydroxy-cyclohexyl-phenyl-cétone, bis(2,6-dimethoxybenzoyl)-2,4,4-trimethyl-pentyl phosphine oxide, 1-[4-(2-hydroxyethoxy)-phenyl]-2-hydroxy-2-methyl-1-propane-1-one, 2,2-dimethoxy-1,2-diphenylethan-1-one et le 2-methyl-1[4-(methylthio)phenyl]-2-morpholinopropan-1-one.

**Patentansprüche**

1. Verfahren zum Verkapseln einer flexiblen elektronischen Vorrichtung mit wenigstens einer flexiblen Schutzfolie gegen die orthogonale Gaspermeation durch einen schützenden Klebstoff gegen die seitliche Gaspermeation, wobei das Verfahren umfasst:

- einen Schritt des Aufbringens einer Schicht eines polymerisierbaren Präkursors des schützenden Klebstoffs gegen die seitliche Gaspermeation auf die Oberfläche der Vorrichtung und/oder auf die Oberfläche der flexiblen Gasschutzfolie, wobei der Klebstoffpräkursor Oligomere mit reaktiven Doppelbindungen eines (Meth)acryltyps und einen Polymerisationsinitiator umfasst,
- dann einen Schritt der Polymerisation des aufgebrachten Klebstoffpräkursors, während er sich zwischen der Vorrichtung und der Gasschutzfolie befindet, so dass er den Klebstoff bildet, der die Schutzfolie mit der Vorrichtung verbindet, während die Vorrichtung gleichzeitig vor seitlicher Gaspermeation geschützt wird.

2. Verfahren nach Anspruch 1, wobei der Klebstoffpräkursor in einem nicht polymerisierten Zustand während des Aufbringens auf die Oberfläche der Vorrichtung und/oder auf die Oberfläche der flexiblen Gasschutzfolie bei einer Schergeschwindigkeit von 1 s$^{-1}$ eine dynamische Viskosität von 10$^{-3}$ bis 10$^1$ Pa·s, vorzugsweise bei einer Schergeschwindigkeit von 1 s$^{-1}$ von 10 mPa·s bis 100.000 mPa·s, vorteilhafterweise bei einer Schergeschwindigkeit von 1 s$^{-1}$ von 50 mPa·s bis 75.000 mPa·s aufweist.

3. Verfahren nach Anspruch 1 oder 2, wobei der Klebstoffpräkursor durch UV-Strahlung polymerisierbar ist.

4. Verfahren nach einem der vorhergehenden Ansprüche, wobei die Schicht des Klebstoffpräkursors in dem nicht polymerisierten Zustand in einer vorbestimmten Dicke aufgebracht wird, wodurch es ermöglicht wird, den nach der Polymerisation gebildeten Klebstoff mit einer Dicke kleiner als oder gleich 3000 Mikrometer, vorzugsweise kleiner als oder gleich 150 Mikrometer, zu versehen.

**5.** Verfahren nach einem der vorhergehenden Ansprüche, wobei der Klebstoffpräkursor (Meth)acrylmonomere, vorzugsweise ein ethoxyliertes Alkylphenolacrylat, umfasst und die Oligomere mit (Meth)acrylgruppen funktionalisiert sind.

**6.** Verfahren nach einem der vorhergehenden Ansprüche, wobei das Oligomer mit reaktiven Doppelbindungen aus der Familie der aromatischen Epoxy(meth)acrylate, difunktionellen aliphatischen (Meth)acrylate oder einer Mischung davon ausgewählt ist oder wobei das Oligomer mit reaktiven Doppelbindungen ein Oligomer ist, das ein aliphatisches Urethandiacrylat und 10 % 2-(2-Ethoxyethoxy)ethylacrylat umfasst.

**7.** Verfahren nach einem der vorhergehenden Ansprüche, wobei der Polymerisationsinitiator aus Folgenden ausgewählt ist: 2-Hydroxy-2-methyl-1-phenylpropan-1-on, 2,4,6-Trimethylbenzoyldiphenylphosphinoxid, 1-Hydroxycyclohexylphenylketon, bis(2,6-Dimethoxybenzoyl)-2,4,4-trimethylpentylphosphinoxid, 1-[4-(2-Hydroxyethoxy)phenyl]-2-hydroxy-2-methyl-1-propan-1-on, 2,2-Dimethoxy-1,2-diphenylethan-1-on und 2-Methyl-1[4-(methylthio)phenyl]-2-morpholinopropan-1-on.

**Claims**

**1.** Method for encapsulating a flexible electronic device with at least one flexible sheet that protects against orthogonal gas permeation by means of an adhesive that protects against lateral gas permeation, the method comprising:

- a step of applying, to the surface of the device and/or to the surface of the flexible gas protection sheet, a layer of a polymerizable precursor of the adhesive that protects against lateral gas permeation, the adhesive precursor comprising oligomers with reactive (meth)acrylic double bonds and a polymerization initiator,
- a subsequent step of polymerizing the applied adhesive precursor when it is located between the device and the gas protection sheet in order to form the adhesive that rigidly connects the protection sheet to the device while protecting the device from lateral gas permeation.

**2.** Method according to claim 1, wherein, in the unpolymerized state and upon application to the surface of the device and/or to the surface of the flexible gas protection sheet, the adhesive precursor exhibits a dynamic viscosity of between $10^{-3}$ and $10^1$ Pa.s for a shear rate of 1 s$^{-1}$, preferably between 10 mPa.s and 100,000 mPa.s for a shear rate of 1 s$^{-1}$, advantageously between 50 mPa.s and 75,000 mPa.s for a shear rate of 1 s$^{-1}$.

**3.** Method according to either claim 1 or claim 2, wherein the adhesive precursor is polymerizable by UV radiation.

**4.** Method according to any of the preceding claims, wherein the adhesive precursor layer is applied in the unpolymerized state to a predetermined thickness, making it possible to provide the adhesive formed after polymerization with a thickness less than or equal to 3000 microns, preferably less than or equal to 150 microns.

**5.** Method according to any of the preceding claims, wherein the adhesive precursor comprises (meth)acrylic monomers, preferably an ethoxylated alkylphenol acrylate, and the oligomers are functionalized with (meth)acrylic groups.

**6.** Method according to any of the preceding claims, wherein the oligomer with reactive double bonds is selected from the family of aromatic epoxy (meth)acrylates, difunctional aliphatic (meth)acrylates, or a mixture thereof, or wherein the oligomer with reactive double bonds is an oligomer comprising an aliphatic urethane diacrylate and 10% 2-(2-ethoxyethoxy)ethyl acrylate.

**7.** Method according to any of the preceding claims, wherein the polymerization initiator is selected from 2-hydroxy-2-methyl-1-phenyl-propan-1-one, 2,4,6-trimethylbenzoyl-diphenyl-phosphine oxide, 1-hydroxy-cyclohexyl-phenyl-ketone, bis(2,6-dimethoxybenzoyl)-2,4,4-trimethyl-pentyl phosphine oxide, 1-[4-(2-hydroxyethoxy)-phenyl]-2-hydroxy-2-methyl-1 -propan-1 -one, 2,2-dimethoxy-1 ,2-diphenylethan-1 -one, and 2-methyl-1[4-(methylthio)phenyl]-2-morpholinopropan-1-one.

FIG. 1 - Etat de la technique

FIG. 2a

FIG. 2b

FIG. 3a

FIG. 3b

FIG. 3c

FIG. 4

FIG. 5

FIG. 6

| Adhésif | PET (rincé à l'IPA) | Oike (rincé à l'IPA) | Oike (Corona) |
|---|---|---|---|
| F 18 | 1.32 N/cm (0.15 N/cm) | 1.32 N/cm (0.15 N/cm) | 1.82 N/cm (0.08 N/cm) |
| S3 | 3.01 N/cm (0.10 N/cm) | 1.00 N/cm (0.07 N/cm) 1.76 N/cm* (0.20 N/cm)* | 2.84 N/cm* (0.16 N/cm)* |

FIG. 7

FIG. 8

FIG. 9

FIG. 9BIS

| Substrat | F18 | S3 |
|---|---|---|
| PET (50µm) | 1.32 N/cm<br>(0.15 N/cm) | 3.01 N/cm<br>(0.10 N/cm) |
| Oike | 3.01 N/cm | 1.76 N/cm |
| VX 25T-2PO | (0.10 N/cm) | (0.20 N/cm) |

FIG. 10

FIG. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013045393 A
- EP 2781568 A
- EP 2637229 A
- US 2014179040 A
- WO 2013140101 A

**Littérature non-brevet citée dans la description**

- **T. G. FOX.** *Bull. Am. Phys. Soc.,* 1956, vol. 1, 123
- Ullmann's Encyclopädie der technischen Chemie. Verlag Chemie, 1980, vol. 19, 18
- Ullmann's Encyclopedia of Industrial Chemistry. VCH, 1992, vol. A21, 169
- **J. BRANDRUP ; E. H. IMMERGUT.** Polymer Handbook. J. Wiley, 1966
- POLYMER HANDBOOK. J. Wiley, 1975
- POLYMER HANDBOOK. J. Wiley, 1989